# EUROPEAN PATENT APPLICATION

(11) **EP 4 498 421 A1**
(43) Date of publication of application: **29.01.2025**
(21) Application number: 24172645.4
(22) Date of filing: 26.04.2024
(51) Int. Cl.: H01L 21/8234, H01L 27/088, H01L 29/06, H01L 29/66, H01L 29/775

(54) **SEMICONDUCTOR DEVICE AND METHOD FOR FABRICATING THE SAME**

(30) Priority: 25.07.2023 KR 20230096984
(71) Applicant: Samsung Electronics Co., Ltd., Suwon-si, Gyeonggi-do 16677 (KR)
(72) Inventor: HWANG, Dong Hoon, 16677 Suwon-si (KR); KIM, Hyo Jin, 16677 Suwon-si (KR); KANG, Myung Il, 16677 Suwon-si (KR); RYU, Tae Hyun, 16677 Suwon-si (KR); PARK, Kyu Nam, 16677 Suwon-si (KR); PARK, Woo Seok, 16677 Suwon-si (KR)
(74) Representative: Marks & Clerk LLP

(57) **Abstract**

A semiconductor device includes a lower pattern. A channel isolation structure (CCW1) and a field insulating layer contact the lower pattern. A gate structure is on the lower pattern, in contact with the channel isolation structure. A channel pattern is on the lower pattern, and includes sheet patterns, each being in contact with the channel isolation structure. A source/drain pattern (150, 250) contacts the channel pattern and the channel isolation structure. The channel isolation structure includes a first region contacting the gate structure and a second region (CCW1_R2) contacting the source/drain pattern. The second region of the channel isolation structure includes portions (CCW1_R21, CCW1_R22) whose widths increase as a distance from a bottom surface of the field insulating layer increases. A width of an uppermost portion (CCW1_R22) of the channel isolation structure is greater than a width of a lowermost portion (CCW1_R21) of the channel isolation structure.

## Description

### TECHNICAL FIELD

The present disclosure relates to semiconductors and, more specifically, to a semiconductor device and a method for fabricating the same.

### DISCUSSION OF THE RELATED ART

Multi-gate transistors has been proposed as an approach for increasing a density of circuits within semiconductor devices. In multi-gate transistors, a fin- or nanowire-shaped multi-channel active pattern (or silicon body) is formed on a substrate and a gate is formed on the surface of the multi-channel active pattern.

Since the multi-gate transistor uses a three-dimensional (3D) channel, scaling of the multi-gate transistor can be more easily achieved. Further, current control capability can be increased without increasing the gate length of the multi-gate transistor. In addition, a short channel effect (SCE) in which the potential of a channel region is affected by a drain voltage can be effectively suppressed.

As a pitch (size) of the semiconductor device decreases, decreasing capacitance and securing electrical stability between contacts in the semiconductor device may be desired.

### SUMMARY

A semiconductor device capable of improving element performance and a degree of integration of elements is disclosed.

A semiconductor device includes a lower pattern extending primarily in a first direction, and having a first sidewall and a second sidewall opposite to each other in a second direction. A channel isolation structure extends primarily in the first direction and is in contact with a first sidewall of the lower pattern. A field insulating layer is in contact with the second sidewall of the lower pattern. A gate structure is disposed on the lower pattern, is in contact with the channel isolation structure, and extends primarily in the second direction. A channel pattern is disposed on the lower pattern, and includes a plurality of sheet patterns spaced apart from each other in a third direction. Each of the sheet patterns is in contact with the channel isolation structure. And a source/drain pattern is in contact with the channel pattern and the channel isolation structure. The channel isolation structure includes a first region in contact with the gate structure and a second region in contact with the source/drain pattern. The second region of the channel isolation structure includes a first portion and a second portion whose widths increase in the second direction as a distance from a bottom surface of the field insulating layer increases. The second portion of the second region of the channel isolation structure is disposed on the first portion of the second region of the channel isolation structure. A width of an uppermost portion of the channel isolation structure in the first portion of the second region of the channel isolation structure is greater than a width of a lowermost portion of the channel isolation structure in the second portion of the second region of the channel isolation structure.

A semiconductor device includes a first gate structure having a first gate electrode and a first gate insulating layer. A second gate structure includes a second gate electrode and a second gate insulating layer and is spaced apart from the first gate structure in a first direction. A first source/drain pattern is disposed adjacent to the first gate structure in a second direction, a second source/drain pattern is disposed adjacent to the second gate structure in the second direction and is spaced apart from the first source/drain pattern in the first direction. A channel isolation structure is disposed between the first gate structure and the second gate structure and between the first source/drain pattern and the second source/drain pattern, and extends primarily in the second direction. A first channel pattern includes a plurality of first sheet patterns, each of the first sheet patterns being in contact with the channel isolation structure and the first source/drain pattern. A second channel pattern includes a plurality of second sheet patterns, each of the second sheet patterns being in contact with the channel isolation structure and the second source/drain pattern. A width of the channel isolation structure between the first gate structure and the second gate structure in the first direction is different from a width of the channel isolation structure in the first direction between the first source/drain pattern and the second source/drain pattern.

A semiconductor device includes a lower pattern extending primarily in a first direction, and having a first sidewall and a second sidewall opposite to the first sidewall in a second direction. A channel isolation structure extends primarily in the first direction and is in contact with a first sidewall of the lower pattern. A field insulating layer is in contact with the second sidewall of the lower pattern. A gate isolation structure is disposed on the field insulating layer, and extends primarily in the first direction. A gate structure is disposed between the channel isolation structure and the gate isolation structure, and is in contact with the channel isolation structure and the gate isolation structure. A channel pattern is disposed on the lower pattern, and includes a plurality of sheet patterns spaced apart from one another in a third direction. Each of the sheet patterns is in contact with the channel isolation structure. A source/drain pattern is disposed between the channel isolation structure and the gate isolation structure, and is in contact with the channel pattern and the channel isolation structure. A part of the source/drain pattern overlaps the channel isolation structure in the third direction, and is disposed across the channel isolation structure.

A method for fabricating a semiconductor device includes forming a first mold fin-type pattern and a second mold fin-type pattern spaced apart from the first mold fin-type pattern in a second direction by a channel isolation trench extending primarily in a first direction. The first mold fin-type pattern includes a first lower pattern and a first upper pattern structure. The second mold fin-type pattern includes a second lower pattern and a second upper pattern structure. The first and second upper pattern structures each include an active pattern and a sacrificial pattern that are alternately stacked A lower channel isolation structure is formed filling the channel isolation trench. A plurality of dummy gate electrodes intersecting the first mold fin-type pattern and the second mold fin-type pattern and extending primarily in the second direction are formed on the first mold fin-type pattern, the second mold fin-type pattern, and the lower channel isolation structure, after removing a part of the lower channel isolation structure exposed between adjacent dummy gate electrodes. A first source/drain recess is formed in the first mold fin-type pattern and a second source/drain recess in the second mold fin-type pattern, after forming the first and second source/drain recesses. An upper channel isolation structure is formed on the lower channel isolation structure. A first source/drain pattern in contact with the lower channel isolation structure and the upper channel isolation structure is formed in the first source/drain recess. A second source/drain pattern in contact with the lower channel isolation structure and the upper channel isolation structure is formed in the second source/drain recess. The dummy gate electrode is removed to form a gate trench exposing the first upper pattern structure and the second upper pattern structure. The sacrificial pattern of the exposed first upper pattern structure is removed to form a first sheet pattern in contact with the first source/drain pattern. The sacrificial pattern of the exposed second upper pattern structure is removed to form a second sheet pattern in contact with the second source/drain pattern. A pre-gate electrode intersecting the first sheet pattern and the second sheet pattern in the gate trench is formed.
At least some of the above and other features of the invention are set out in the claims.

### BRIEF DESCRIPTION OF THE DRAWINGS

The above and other aspects and features of the present disclosure will become more apparent by describing in detail example embodiments thereof with reference to the attached drawings, in which:
FIG. 1 is a layout diagram illustrating a semiconductor device according to embodiments of the present disclosure;
FIGS. 2 to 5 are cross-sectional views taken along lines A-A, B-B, C-C and D-D of FIG. 1;
FIG. 6 is a diagram illustrating the shape of a first sheet pattern of FIG. 2;
FIG. 7 is a schematic plan view of part P of FIG. 1;
FIG. 8 is an enlarged view of part Q of FIG. 4;
FIG. 9 is an enlarged view of part S of FIG. 5;
FIGS. 10 and 11 are diagrams illustrating a semiconductor device according to embodiments of the present disclosure;
FIGS. 12 and 13 are diagrams illustrating a semiconductor device according to embodiments of the present disclosure;
FIGS. 14 and 15 are diagrams illustrating a semiconductor device according to embodiments of the present disclosure;
FIGS. 16 to 19 are diagrams each illustrating a semiconductor device according to embodiments of the present disclosure;
FIGS. 20 and 21 are diagrams each illustrating a semiconductor device according to embodiments of the present disclosure;
FIGS. 22 to 24 are diagrams each illustrating a semiconductor device according to embodiments of the present disclosure;
FIGS. 25 and 26 are diagrams each illustrating a semiconductor device according to embodiments of the present disclosure;
FIGS. 27 and 28 are diagrams illustrating a semiconductor device according to embodiments of the present disclosure;
FIG. 29 is a diagram illustrating a semiconductor device according to embodiments of the present disclosure; and
FIGS. 30 to 59 are views illustrating the intermediate steps of a method for fabricating a semiconductor device according to embodiments of the present disclosure.

### DETAILED DESCRIPTION OF THE EMBODIMENTS

Although the terms first, second, etc. may be used herein to describe various elements or components, these elements or components should not necessarily be limited by these terms. These terms are used to distinguish one element or component from another element or component. Thus, a first element or component discussed below could be termed a second element or component without departing from the teachings of the present disclosure. A reference to one layer or portion being "on" another layer or portion does not exclude there being intervening layers.

In the drawing of the semiconductor device according to embodiments of the present disclosure, a transistor including nanowires or nanosheets is illustrated as an example, but the present disclosure is not necessarily limited thereto. The technical idea of the present disclosure can be applied to transistors based on two-dimensional materials (2D material based FETs) and heterostructures thereof.

Further, the semiconductor device according to embodiments of the present disclosure may include a fin-type transistor (FinFET) including a channel region having a fin-type pattern shape, a tunneling transistor (tunneling FET), or a three-dimensional (3D) transistor. The semiconductor device, according to embodiments of the present disclosure, may include a bipolar junction transistor, a lateral double diffusion MOS (LDMOS) transistor, or the like.

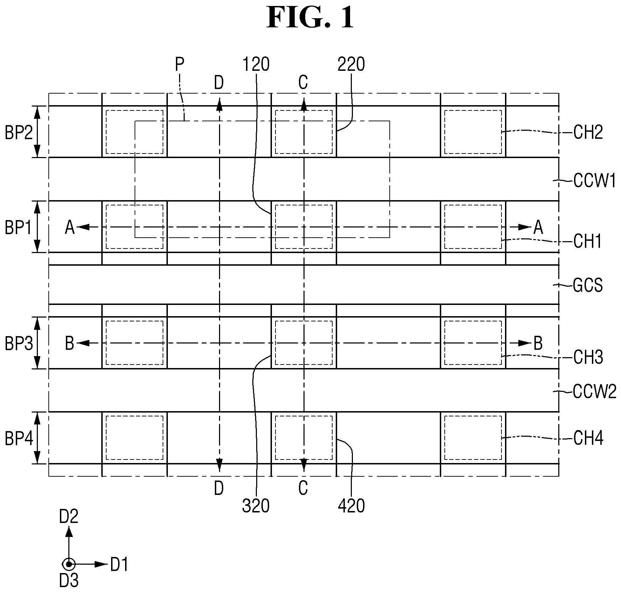

A semiconductor device according to embodiments of the present disclosure will be described with reference to FIGS. 1 to 9.

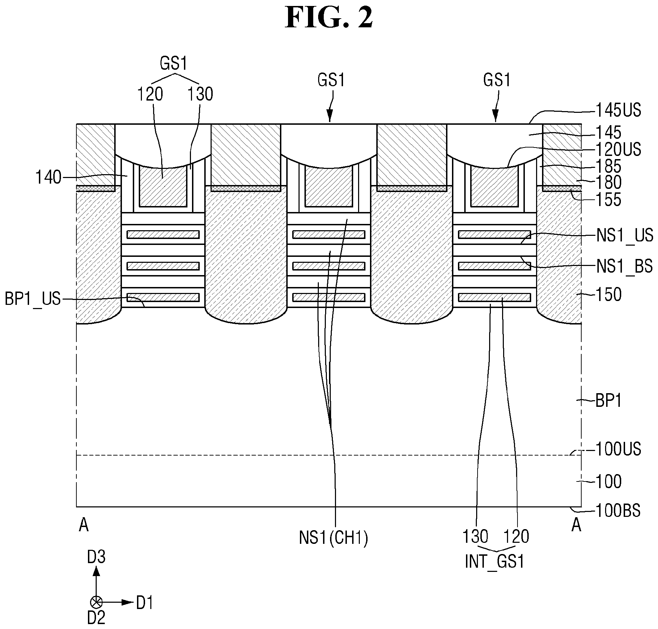

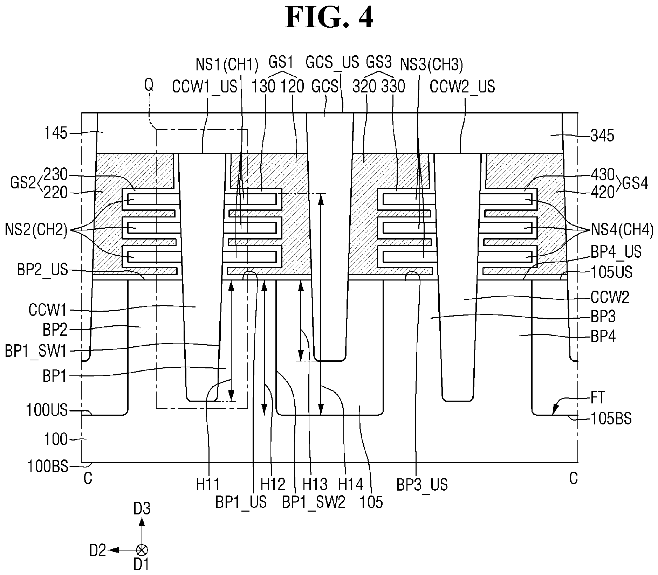

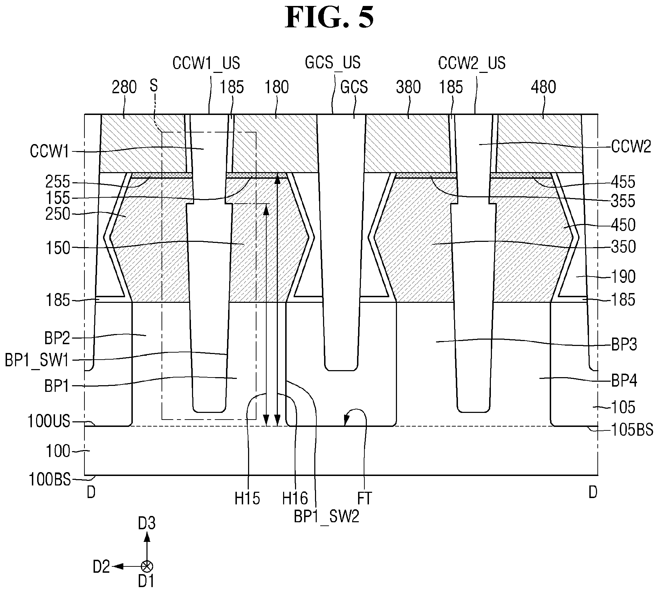

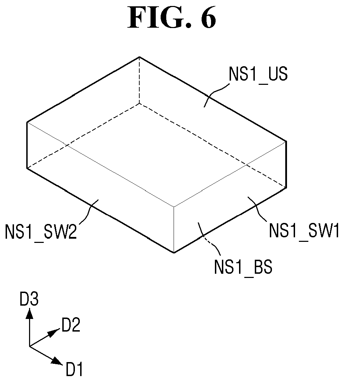

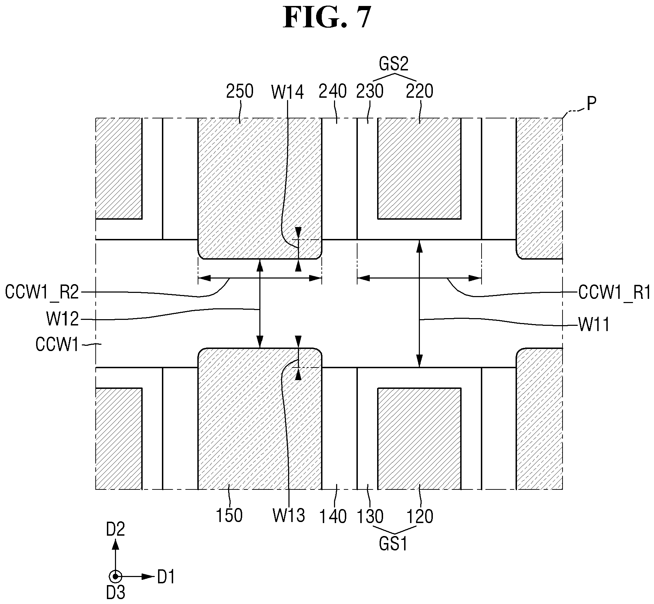

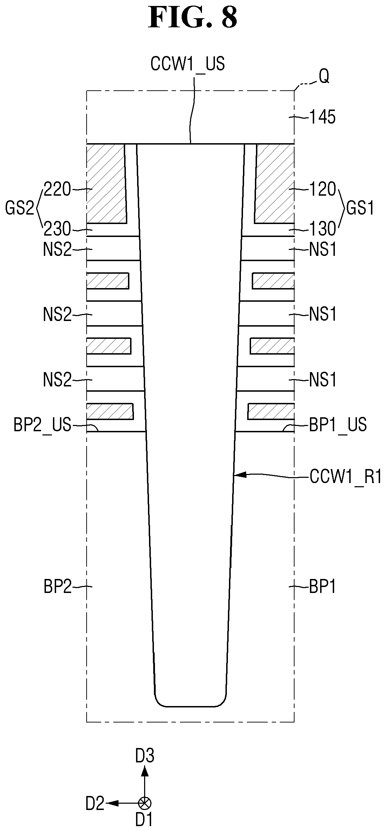

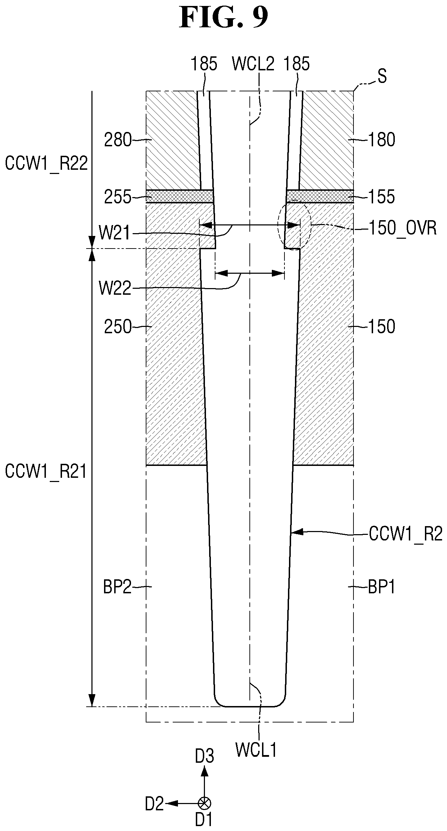

FIG. 1 is a layout diagram illustrating a semiconductor device according to embodiments of the present disclosure. FIGS. 2 to 5 are cross-sectional views taken along lines A-A, B-B, C-C and D-D of FIG. 1. FIG. 6 is a diagram illustrating the shape of a first sheet pattern of FIG. 2. FIG. 7 is a schematic plan view of part P of FIG. 1. FIG. 8 is an enlarged view of part Q of FIG. 4. FIG. 9 is an enlarged view of part S of FIG. 5.

For reference, in FIG. 1, the illustration of source/drain contacts 180, 280, 380, and 480 and the like is omitted. Further, FIG. 7 may be taken between the source/drain contacts 180 and 280 and sheet patterns NS1 and NS2 disposed at the uppermost portion.

Referring to FIGS. 1 to 9, the semiconductor device, according to embodiments of the present disclosure, may include a first lower pattern BP1, a second lower pattern BP2, a third lower pattern BP3, a fourth lower pattern BP4, a first channel pattern CH1, a second channel pattern CH2, a third channel pattern CH3, a fourth channel pattern CH4, a first channel isolation structure CCW1, a second channel isolation structure CCW2, a first gate electrode 120, a second gate electrode 220, a third gate electrode 320, a fourth gate electrode 420, a first source/drain pattern 150, a second source/drain pattern 250, a third source/drain pattern 350, a fourth source/drain pattern 450, and a gate isolation structure GCS.

A first substrate 100 may include a first surface 100US and a second surface 100BS opposite to each other in a third direction D3. The gate electrodes 120, 220, 320, and 420, the source/drain patterns 150, 250, 350, and 450, and the channel patterns CH1, CH2, CH3, and CH4 may be disposed on the first surface 100US of the first substrate, so that the first surface 100US of the first substrate may be the upper surface of the first substrate 100. The second surface 100BS of the first substrate opposite to the first surface 100US of the first substrate may be the bottom surface of the first substrate 100.

The first substrate 100 may be made of a semiconductor material or may include a semiconductor material. The first substrate 100 may be a silicon substrate or silicon-on-insulator (SOI) substrate. Alternatively, the first substrate 100 may include, for example, silicon germanium, silicon germanium on insulator (SGOI), indium antimonide, a lead tellurium compound, indium arsenide, indium phosphide, gallium arsenide, or gallium antimonide, but is not necessarily limited thereto.

The first lower pattern BP1 and the second lower pattern BP2 may each protrude from the first substrate 100 in the third direction D3. The first lower pattern BP1 and the second lower pattern BP2 may protrude from the first surface 100US of the first substrate. The first lower pattern BP1 and the second lower pattern BP2 may each extend primarily in the first direction D1. The first lower pattern BP1 and the second lower pattern BP2 may be spaced apart from each other in a second direction D2.

The third lower pattern BP3 and the fourth lower pattern BP4 may each protrude from the first substrate 100 in the third direction D3. The third lower pattern BP3 and the fourth lower pattern BP4 may protrude from the first surface 100US of the first substrate. Each of the third lower pattern BP3 and the fourth lower pattern BP4 may be elongated in the first direction D1. The third lower pattern BP3 and the fourth lower pattern BP4 may be spaced apart from each other in the second direction D2.

For example, the third direction D3 may be the thickness direction of the first substrate 100. Each of the first direction D1 and the second direction D2 may intersect the third direction D3. The first direction D1 may intersect the second direction D2.

The first lower pattern BP1 and the third lower pattern BP3 may be disposed between the second lower pattern BP2 and the fourth lower pattern BP4. The first lower pattern BP1 may be disposed between the second lower pattern BP2 and the third lower pattern BP3.

The first lower pattern BP1 and the third lower pattern BP3 may be isolated by a fin trench FT (see figures 4 and 5) extending primarily in the first direction D1. For example, the first surface 100US of the first substrate may be the bottom surface of the fin trench FT.

As used herein, the phrase "extending primarily in a direction" means that the structure has a longest degree of extension in that direction, even though the structure may extend, to a lesser extent, in other directions as well.

In the case of the first lower pattern BP1, for example, the first lower pattern BP1 may include a first sidewall BP1_SW1 and a second sidewall BP1_SW2 opposite to each other in the second direction D2. The first sidewall BP1_SW1 of the first lower pattern and the second sidewall BP1_SW2 of the first lower pattern may extend primarily in the first direction D1. The second sidewall BP1_SW2 of the first lower pattern may be defined by the fin trench FT. The first sidewall BP1_SW1 of the first lower pattern is not defined by the fin trench FT.

Similarly to the first lower pattern BP1, the second to fourth lower patterns BP2, BP3, and BP4 may include first sidewalls and second sidewalls opposite to each other in the second direction D2. For example, since the second sidewall BP1_SW2 of the first lower pattern and the second sidewall of the third lower pattern BP3 are defined by the fin trench FT, the second sidewall BP1_SW2 of the first lower pattern may face the second sidewall of the third lower pattern BP3.

The first lower pattern BP1 and the second lower pattern BP2 may be disposed in the region where transistors of the same conductivity type are formed. The third lower pattern BP3 and the fourth lower pattern BP4 may be disposed in the region where transistors of the same conductivity type are formed. For example, the first lower pattern BP1 may be disposed in a PMOS formation region, and the third lower pattern BP3 may be disposed in an NMOS formation region. For an example, the first lower pattern BP1 and the third lower pattern BP3 may be disposed in the PMOS formation region. For an example, the first lower pattern BP1 and the third lower pattern BP3 may be disposed in the NMOS formation region.

Each of the first to fourth lower patterns BP1, BP2, BP3, and BP4 may be formed by etching a part of the first substrate 100, or may include an epitaxial layer grown from the first substrate 100. Each of the first to fourth lower patterns BP1, BP2, BP3, and BP4 may include silicon or germanium, which is an elemental semiconductor material. In addition, each of the lower patterns BP1, BP2, BP3, and BP4 may include a compound semiconductor, for example, a group IV-IV compound semiconductor or a group III-V compound semiconductor.

The group IV-IV compound semiconductor may be a binary compound or a ternary compound including at least two elements of carbon (C), silicon (Si), germanium (Ge) and tin (Sn), or the above-mentioned compound doped with a group IV element.

The group III-V compound semiconductor may be, for example, a binary compound, a ternary compound or a quaternary compound formed by combining aluminum (Al), gallium (Ga) and/or indium (In) which are group III elements with one of phosphorus (P), arsenic (As) and antimony (Sb) which are group V elements.

The first lower pattern BP1 and the second lower pattern BP2 include the same material. The third lower pattern BP3 and the fourth lower pattern BP4 include the same material.

A field insulating layer 105 is disposed on the first substrate 100. For example, the field insulating layer 105 may be disposed on the first surface 100US of the first substrate. The field insulating layer 105 may fill at least a part of the fin trench FT that isolates the first lower pattern BP1 and the third lower pattern BP3.

In cross-sectional view, the first lower pattern BP1 and the second lower pattern BP2 may be disposed between the field insulating layers 105 adjacent in the second direction D2. The third lower pattern BP3 and the fourth lower pattern BP4 may be disposed between the field insulating layers 105 adjacent in the second direction D2.

The field insulating layer 105 is not disposed on an upper surface BP1_US of the first lower pattern, an upper surface BP2_US of the second lower pattern, an upper surface BP3_US of the third lower pattern, and an upper surface BP4_US of the fourth lower pattern.

The field insulating layer 105 may be in contact with the second sidewall BP1_SW2 of the first lower pattern and the second sidewall of the third lower pattern BP3. For example, the field insulating layer 105 may entirely cover the second sidewall BP1_SW2 of the first lower pattern and the second sidewall of the third lower pattern BP3. For example, the field insulating layer 105 may cover a part of the second sidewall BP1_SW2 of the first lower pattern and/or a part of the second sidewall of the third lower pattern BP3.

The field insulating layer 105 may include an upper surface 105US and a bottom surface 105BS opposite to each other in the third direction D3. The bottom surface 105BS of the field insulating layer may face the first substrate 100. For example, the bottom surface 105BS of the field insulating layer may be in contact with the first substrate 100.

Although it is illustrated that the upper surface 105US of the field insulating layer 105 has a flat shape, this is for simplicity of description, and the present disclosure is not necessarily limited thereto. The field insulating layer 105 may include, for example, an oxide layer, a nitride layer, an oxynitride layer, or a combination layer thereof. Although the field insulating layer 105 is illustrated as being a single layer, this is for simplicity of description, and the present disclosure is not necessarily limited thereto.

A plurality of first channel patterns CH1 may be disposed on the first lower pattern BP1. Each of the first channel patterns CH1 may overlap the first lower pattern BP1 in the third direction D3. The plurality of first channel patterns CH1 may be aligned in the first direction D1. As used herein, the phrase "aligned in the direction" may mean that the listed elements each have a longest axis that are the same as one another.

A plurality of second channel patterns CH2 may be disposed on the second lower pattern BP2. Each of the second channel patterns CH2 may overlap the second lower pattern BP2 in the third direction D3. The plurality of second channel patterns CH2 may be aligned in the first direction D1. The second channel pattern CH2 may correspond to the first channel pattern CH1. The first channel pattern CH1 and the second channel pattern CH2 corresponding to each other may be spaced apart from each other in the second direction D2.

A plurality of third channel patterns CH3 may be disposed on the third lower pattern BP3. Each of the third channel patterns CH3 may overlap the third lower pattern BP3 in the third direction D3. The plurality of third channel patterns CH3 may be aligned in the first direction D1.

A plurality of fourth channel patterns CH4 may be disposed on the fourth lower pattern BP4. Each of the fourth channel patterns CH4 may overlap the fourth lower pattern BP4 in the third direction D3. The plurality of fourth channel patterns CH4 may be aligned in the first direction D1. The fourth channel pattern CH4 may correspond to the third channel pattern CH3. The third channel pattern CH3 and the fourth channel pattern CH4 corresponding to each other may be spaced apart from each other in the second direction D2.

Each of the first channel pattern CH1, the second channel pattern CH2, the third channel pattern CH3, and the fourth channel pattern CH4 may include a plurality of sheet patterns spaced apart from each other in the third direction D3. Although it is illustrated that each of the first channel pattern CH1, the second channel pattern CH2, the third channel pattern CH3, and the fourth channel pattern CH4 includes three sheet patterns, this is for simplicity of description, and the present disclosure is not necessarily limited thereto.

The first channel pattern CH1 may include a plurality of first sheet patterns NS1 (Fig. 2). The plurality of first sheet patterns NS1 may be disposed on an upper surface BP1_US of the first lower pattern. The plurality of first sheet patterns NS1 are arranged in the third direction D3 on the first lower pattern BP1. The first sheet patterns NS1 are spaced apart from each other in the third direction D3. Each of the first sheet patterns NS1 includes an upper surface NS1_US and a bottom surface NS1_BS opposite to each other in the third direction D3. For example, the upper surface NS1_US of the first sheet pattern disposed at the uppermost portion may be the upper surface of the first channel pattern CH1.

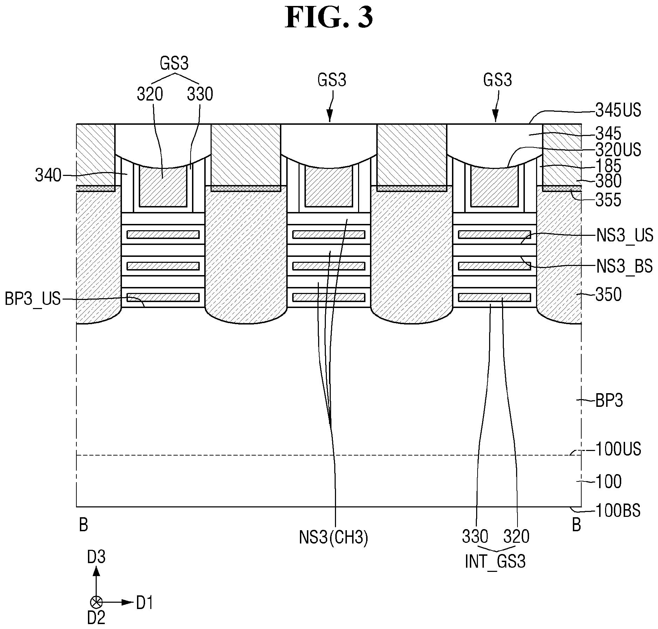

The third channel pattern CH3 may include a plurality of third sheet patterns NS3 (Fig. 3). The plurality of third sheet patterns NS3 may be disposed on the upper surface BP3_US of the third lower pattern. The plurality of third sheet patterns NS3 are arranged in the third direction D3 on the third lower pattern BP3. The third sheet patterns NS3 are spaced apart from each other in the third direction D3. Each of the third sheet patterns NS3 includes an upper surface NS3_US and a bottom surface NS3_BS opposite to each other in the third direction D3.

The second channel pattern CH2 may include a plurality of second sheet patterns NS2 (Fig. 4). The plurality of second sheet patterns NS2 may be disposed on the upper surface BP2_US of the second lower pattern. The second sheet patterns NS2 are spaced apart from each other in the third direction D3. The fourth channel pattern CH4 may include a plurality of fourth sheet patterns NS4. The plurality of fourth sheet patterns NS4 may be disposed on the upper surface BP4_US of the fourth lower pattern. The fourth sheet patterns NS4 are spaced apart from each other in the third direction D3.

In the case of the first sheet pattern NS1, for example, the first sheet pattern NS1 may include first sidewalls NS1_SW1 opposite to one another in the first direction D1, and second sidewalls NS1_SW2 opposite to one another in the second direction D2. The upper surface NS1_US of the first sheet pattern and the bottom surface NS1_BS of the first sheet pattern may be connected by the first sidewalls NS1_SW1 of the first sheet pattern and the second sidewalls NS1_SW2 of the first sheet pattern. The first sidewalls NS1_SW1 of the first sheet pattern are connected to and in contact with the first source/drain pattern 150 to be described later. The description of the first sheet pattern NS1 may also be applied to the second to fourth sheet patterns NS2, NS3, and NS4.

Each of the sheet patterns NS1, NS2, NS3, and NS4 may include any one of silicon or germanium as an elemental semiconductor material, a group IV-IV compound semiconductor, and a group III-V compound semiconductor. The first sheet pattern NS1 and the second sheet pattern NS2 may include the same material as the first lower pattern BP1, or may include a material different from that of the first lower pattern BP1. The third sheet pattern NS3 and the fourth sheet pattern NS4 may include the same material as the third lower pattern BP3, or a material different from that of the third lower pattern BP3.

In the semiconductor device, according to embodiments of the present disclosure, each of the first to fourth lower patterns BP1, BP2, BP3, and BP4 may be a silicon lower pattern including silicon. Each of the first to fourth sheet patterns NS1, NS2, NS3, and NS4 may be a silicon sheet pattern including silicon.

The first channel isolation structure CCW1 may be disposed on the first surface 100US of the first substrate. The first channel isolation structure CCW1 may be disposed between the first lower pattern BP1 and the second lower pattern BP2. The first channel isolation structure CCW1 may extend primarily in the first direction D1.

The first channel isolation structure CCW1 may isolate the first lower pattern BP1 and the second lower pattern BP2. The first channel isolation structure CCW1 isolates the first channel pattern CH1 and the second channel pattern CH2. The first lower pattern BP1 and the second lower pattern BP2 cover a part of the sidewall of the first channel isolation structure CCW1. The sidewall of the first channel isolation structure CCW1 may extend primarily in the first direction D1.

The first channel isolation structure CCW1 may be in contact with the first lower pattern BP1 and the second lower pattern BP2. The first channel isolation structure CCW1 may be in contact with the first sidewall BP1_SW1 of the first lower pattern and the first sidewall of the second lower pattern BP2. The first sidewall BP1_SW1 of the first lower pattern faces the first sidewall of the second lower pattern BP2.

The first channel pattern CH1 and the second channel pattern CH2 are in contact with the first channel isolation structure CCW1. The plurality of first sheet patterns NS1 and the plurality of second sheet patterns NS2 are in contact with the first channel isolation structure CCW1. The first sheet pattern NS 1 and the second sheet pattern NS2 may protrude from the sidewall of the first channel isolation structure CCW1 in the second direction D2. In the case of the first sheet pattern NS1, for example, one of the second sidewalls NS1_SW2 of the first sheet pattern is in contact with the first channel isolation structure CCW1. One of the second sidewalls of the second sheet pattern NS2 is in contact with the first channel isolation structure CCW1.

The second channel isolation structure CCW2 may be disposed on the first surface 100US of the first substrate. The second channel isolation structure CCW2 may be disposed between the third lower pattern BP3 and the fourth lower pattern BP4. The second channel isolation structure CCW2 may extend primarily in the first direction D1. The second channel isolation structure CCW2 is spaced apart from the first channel isolation structure CCW1 in the second direction D2.

The second channel isolation structure CCW2 may isolate the third lower pattern BP3 and the fourth lower pattern BP4. The second channel isolation structure CCW2 isolates the third and fourth channel patterns CH3 and CH4. The third lower pattern BP3 and the fourth lower pattern BP4 cover a part of the sidewall of the second channel isolation structure CCW2. The sidewall of the second channel isolation structure CCW2 may extend primarily in the first direction D1.

The second channel isolation structure CCW2 may be in contact with the third lower pattern BP3 and the fourth lower pattern BP4. The second channel isolation structure CCW2 may be in contact with the first sidewall of the third lower pattern BP3 and the first sidewall of the fourth lower pattern BP4. The first sidewall of the third lower pattern BP3 faces the first sidewall of the fourth lower pattern BP4.

The third channel pattern CH3 and the fourth channel pattern CH4 are in contact with the second channel isolation structure CCW2. The plurality of third sheet patterns NS3 and the plurality of fourth sheet patterns NS4 are in contact with the second channel isolation structure CCW2. The third sheet pattern NS3 and the fourth sheet pattern NS4 may protrude from the sidewall of the second channel isolation structure CCW2 in the second direction D2. One of the second sidewalls of the third sheet pattern NS3 is in contact with the second channel isolation structure CCW2. One of the second sidewalls of the fourth sheet pattern NS4 is in contact with the second channel isolation structure CCW2.

Each of the first channel isolation structure CCW1 and the second channel isolation structure CCW2 includes an electrically insulating material. Each of the first channel isolation structure CCW1 and the second channel isolation structure CCW2 may include, for example, silicon nitride (SiN), silicon oxynitride (SiON), silicon oxide (SiO2), silicon oxynitride (SiOCN), silicon boron nitride (SiBN), silicon oxyboron nitride (SiOBN), silicon oxycarbide (SiOC), aluminum oxide (AlO), or a combination thereof. Although each of the first channel isolation structure CCW1 and the second channel isolation structure CCW2 may be a single layer, this is merely for simplicity of description, and the present disclosure is not necessarily limited thereto. Since the first channel isolation structure CCW1 and the second channel isolation structure CCW2 are formed at the same time, the first channel isolation structure CCW1 and the second channel isolation structure CCW2 include the same material.

Since the description of the second channel isolation structure CCW2 may be substantially the same as that of the first channel isolation structure CCW1, the description of the first channel isolation structure CCW1 may be applied to the second channel isolation structure CCW2. The shape of the first channel isolation structure CCW1 will be described in detail later.

In the semiconductor device, according to embodiments of the present disclosure, a depth H11 (Fig. 4) from the upper surface BP1_US of the first lower pattern to the lowermost portion of the first channel isolation structure CCW1 may be smaller than a depth H12 from the upper surface BP1_US of the first lower pattern to the bottom surface 105BS of the field insulating layer.

The gate isolation structure GCS may be disposed on the first surface 100US of the first substrate 100. The gate isolation structure GCS may extend primarily in the first direction D1. The gate isolation structure GCS may be disposed on the field insulating layer 105. A part of the gate isolation structure GCS may be disposed in an upper interlayer insulating layer 190.

The gate isolation structure GCS may be in contact with the field insulating layer 105. The gate isolation structure GCS may protrude more in the third direction D3 than the upper surface 105US of the field insulating layer. For example, a part of the gate isolation structure GCS may be inserted into the field insulating layer 105.

The gate isolation structure GCS is disposed between the first channel isolation structure CCW1 and the second channel isolation structure CCW2. The channel patterns CH1, CH2, CH3, and CH4 are disposed between the channel isolation structures CCW1 and CCW2 and the gate isolation structure GCS.

For example, the depth H11 from the upper surface BP1_US of the first lower pattern to the lowest portion of the first channel isolation structure CCW1 may be greater than a depth H13 from the upper surface BP1_US of the first lower pattern to the lowest portion of the gate isolation structure GCS.

The gate isolation structure GCS includes an electrically insulating material. The gate isolation structure GCS may include, for example, silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), aluminum oxide (AlO), or a combination thereof. Although the gate isolation structure GCS may be a single layer, it is merely for simplicity of description and the present disclosure is not necessarily limited thereto.

First to fourth gate structures GS1, GS2, GS3, and GS4 may be disposed on the first surface 100US of the first substrate. The first to fourth gate structures GS1, GS2, GS3, and GS4 may be in contact with the upper surface 105US of the field insulating layer.

The plurality of first gate structures GS1 may be disposed between the first channel isolation structure CCW1 and the gate isolation structure GCS. The plurality of first gate structures GS1 may be in contact with the first channel isolation structure CCW1 and the gate isolation structure GCS. The first gate structures GS1 may be adjacent to each other in the first direction D1.

The first gate structure GS1 may be disposed on the first lower pattern BP1. For example, the first gate structure GS1 may be in contact with the upper surface BP1_US of the first lower pattern. The first channel pattern CH1 may be disposed between the first gate structure GS1 and the first channel isolation structure CCW1. Each of the first sheet patterns NS1 may be disposed between the first gate structure GS1 and the first channel isolation structure CCW1. Since each of the first sheet patterns NS1 is in contact with the first channel isolation structure CCW1, the first gate structure GS1 does not surround each of the first sheet patterns NS1 in cross-sectional view.

The first gate structure GS1 may include the first gate electrode 120 and a first gate insulating layer 130. The first gate electrode 120 may be disposed on the first lower pattern BP1. The first gate insulating layer 130 may be disposed between the first gate electrode 120 and the first channel pattern CH1. For example, the first gate insulating layer 130 may be disposed between the first gate electrode 120 and the first sheet pattern NS1.

The first gate insulating layer 130 may extend primarily along the upper surface 105US of the field insulating layer and the upper surface BP1_US of the first lower pattern. The first gate insulating layer 130 may be in contact with the upper surface 105US of the field insulating layer and the upper surface BP1_US of the first lower pattern. In cross-sectional view of FIG. 4, the first gate insulating layer 130 may extend primarily along the sidewall of the first channel isolation structure CCW1. The first gate electrode 120 is not in contact with the sidewall of the first channel isolation structure CCW1. The first gate insulating layer 130 does not extend along the sidewall of the gate isolation structure GCS. The first gate electrode 120 may be in contact with the sidewall of the gate isolation structure GCS. The first gate insulating layer 130 may be disposed along a part of the circumference of the first sheet pattern NS1.

The first gate structure GS1 may include a first inner gate structure INT_GS1. The first inner gate structure INT_GS1 may be disposed between the first lower pattern BP1 and the first sheet pattern NS1, and between the first sheet patterns NS1 adjacent in the third direction D3. The first inner gate structure INT_GS1 is in contact with the upper surface BP1_US of the first lower pattern, the upper surface NS1_US of the first sheet pattern, and the bottom surface NS1_BS of the first sheet pattern. The first gate insulating layer 130 included in the first inner gate structure INT_GS1 may be in contact with the first source/drain pattern 150 to be described later.

Since the description of the second to fourth gate structures GS2, GS3, and GS4 may be substantially the same as that of the first gate structure GS1 described above, the second to fourth gate structures GS2, GS3, and GS4 will be briefly described.

The plurality of second gate structures GS2 may be disposed between the first channel isolation structure CCW1 and the gate isolation structure GCS. The plurality of second gate structures GS2 may be in contact with the first channel isolation structure CCW1 and the gate isolation structure GCS. The first channel isolation structure CCW1 may be disposed between the first gate structure GS1 and the second gate structure GS2. The second gate structures GS2 may be adjacent to each other in the first direction D1. The second gate structure GS2 may be spaced apart from the first gate structure GS1 in the second direction D2.

The second gate structure GS2 may be disposed on the second lower pattern BP2. For example, the second gate structure GS2 may be in contact with the upper surface BP2_US of the second lower pattern. The second channel pattern CH2 may be disposed between the second gate structure GS2 and the first channel isolation structure CCW1. Each of the second sheet patterns NS2 may be disposed between the second gate structure GS2 and the first channel isolation structure CCW1. The second gate structure GS2 may include the second gate electrode 220 and a second gate insulating layer 230. The second gate structure GS2 may include a second inner gate structure disposed between the second lower pattern BP2 and the second sheet pattern NS2, and between the second sheet patterns NS2 adjacent in the third direction D3.

The plurality of third gate structures GS3 may be disposed between the second channel isolation structure CCW2 and the gate isolation structure GCS. The plurality of third gate structures GS3 may be in contact with the second channel isolation structure CCW2 and the gate isolation structure GCS. The third gate structures GS3 may be adjacent to each other in the first direction D1. The third gate structure GS3 may be spaced apart from the first gate structure GS1 in the second direction D2.

The third gate structure GS3 may be disposed on the third lower pattern BP3. For example, the third gate structure GS3 may be in contact with the upper surface BP3_US of the third lower pattern. The third channel pattern CH3 may be disposed between the third gate structure GS3 and the second channel isolation structure CCW2 (Fig. 4). Each of the third sheet patterns NS3 may be disposed between the third gate structure GS3 and the second channel isolation structure CCW2. The third gate structure GS3 may include the third gate electrode 320 and the third gate insulating layer 330. The third gate structure GS3 may include a third inner gate structure INT_GS3 (Fig. 3) disposed between the third lower pattern BP3 and the third sheet pattern NS3, and between the third sheet patterns NS3 adjacent to each other in the third direction D3. The third gate insulating layer 330 included in the third inner gate structure INT_GS3 may be in contact with the third source/drain pattern 350 to be described later.

The plurality of fourth gate structures GS4 may be disposed between the second channel isolation structure CCW2 and the gate isolation structure GCS. The plurality of fourth gate structures GS4 may be in contact with the second channel isolation structure CCW2 and the gate isolation structure GCS. The second channel isolation structure CCW2 may be disposed between the third gate structure GS3 and the fourth gate structure GS4. The fourth gate structures GS4 may be adjacent to each other in the first direction D1. The fourth gate structure GS4 may be spaced apart from the third gate structure GS3 in the second direction D2.

The fourth gate structure GS4 may be disposed on the fourth lower pattern BP4. For example, the fourth gate structure GS4 may be in contact with the upper surface BP4_US of the fourth lower pattern. The fourth channel pattern CH4 may be disposed between the fourth gate structure GS4 and the second channel isolation structure CCW2. Each of the fourth sheet patterns NS4 may be disposed between the fourth gate structure GS4 and the second channel isolation structure CCW2. The fourth gate structure GS4 may include the fourth gate electrode 420 and the fourth gate insulating layer 330. The fourth gate structure GS4 may include a fourth inner gate structure disposed between the fourth lower pattern BP4 and the fourth sheet pattern NS4, and between the fourth sheet patterns NS4 adjacent to each other in the third direction D3.

Although it is illustrated in the cross-sectional views of FIGS. 2 and 3 that the upper surface 120US of the first gate electrode and the upper surface 320US of the third gate electrode are concave curved surfaces, the present disclosure is not necessarily limited thereto. The upper surface 120US of the first gate electrode and the upper surface 320US of the third gate electrode may be flat surfaces.

In the cross-sectional view of FIG. 4, the upper surface of the first gate electrode 120 and the upper surface of the second gate electrode 220 may be flat surfaces. The upper surface of the third gate electrode 320 and the upper surface of the fourth gate electrode 420 may be flat surfaces.

The first to fourth gate electrodes 120, 220, 320, and 420 may include a metal, a metal alloy, an electrically conductive metal nitride, a metal silicide, a doped semiconductor material, a conductive metal oxide, and/or a conductive metal oxynitride. The first to fourth gate electrodes 120, 220, 320, and 420 may include, for example, titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlCN), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (NiPt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V) and a combination thereof, but are not necessarily limited thereto. The conductive metal oxide and the conductive metal oxynitride may include a form in which the above-mentioned material is oxidized, but are not necessarily limited thereto.

The first to fourth gate insulating layers 130, 230, 330, and 430 may include silicon oxide, silicon oxynitride, silicon nitride, or a high-k material having a dielectric constant greater than that of silicon oxide. As used herein, the term "high-k" may be understood to mean a material having a dielectric constant that is at least as high as that of silicon oxide. The high-k material may include, for example, boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and/or lead zinc niobate.

Although each of the first to fourth gate insulating layers 130, 230, 330, and 430 is illustrated as being a single layer, this is for simplicity of description, and the present disclosure is not necessarily limited thereto. Each of the first to fourth gate insulating layers 130, 230, 330, and 430 may include a plurality of layers. In the case of the first gate insulating layer 130, for example, the first gate insulating layer130 may include a high-k insulating layer, and an interfacial layer disposed between the first channel pattern CH1 and the first gate electrode 120. For example, the interfacial layer might not be formed along the profile of the upper surface 105US of the field insulating layer.

The semiconductor device, according to embodiments of the present disclosure, may include a negative capacitor (NC) FET using a negative capacitor (NC). For example, each of the first to fourth gate insulating layers 130, 230, 330, and 430 may include a ferroelectric material layer having ferroelectric properties and a paraelectric material layer having paraelectric properties.

The ferroelectric material layer may have a negative capacitance, and the paraelectric material layer may have a positive capacitance. For example, when two or more capacitors are connected in series and the capacitance of each capacitor has a positive value, the total capacitance becomes smaller than the capacitance of each capacitor. When at least one of the capacitances of two or more capacitors connected in series has a negative value, the total capacitance may have a positive value and may be greater than the absolute value of each capacitance.

When a ferroelectric material layer having a negative capacitance and a paraelectric material layer having a positive capacitance are connected in series, the total capacitance value of the ferroelectric material layer and the paraelectric material layer connected in series may increase. By using the principle that the total capacitance value is increased, the transistor containing the ferroelectric material layer may have a subthreshold swing (SS) that is lower than or equal to a threshold voltage lower than 60 mV/decade at room temperature.

The ferroelectric material layer may have ferroelectric properties. The ferroelectric material layer may include, for example, hafnium oxide, hafnium zirconium oxide, barium strontium titanium oxide, barium titanium oxide, and/or lead zirconium titanium oxide. In this case, as one example, the hafnium zirconium oxide may be a material containing hafnium oxide doped with zirconium (Zr). As an example, the hafnium zirconium oxide may be a compound of hafnium (Hf), zirconium (Zr), and oxygen (O).

The ferroelectric material layer may further include a dopant doped therein. For example, the dopant may include aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and/or tin (Sn). The type of dopant included in the ferroelectric material layer may vary depending on which ferroelectric material is included in the ferroelectric material layer.

When the ferroelectric material layer includes hafnium oxide, the dopant included in the ferroelectric material layer may include, for example, gadolinium (Gd), silicon (Si), zirconium (Zr), aluminum (Al), and/or yttrium (Y).

When the dopant is aluminum (Al), the ferroelectric material layer may include 3 to 8 atomic percent (at%) of aluminum. In this case, the ratio of the dopant may be a ratio of aluminum to the sum of hafnium and aluminum.

When the dopant is silicon (Si), the ferroelectric material layer may include 2 to 10 at% of silicon. When the dopant is yttrium (Y), the ferroelectric material layer may include 2 to 10 at% of yttrium. When the dopant is gadolinium (Gd), the ferroelectric material layer may include 1 to 7 at% of gadolinium. When the dopant is zirconium (Zr), the ferroelectric material layer may include 50 to 80 at% of zirconium.

The paraelectric material layer may have paraelectric properties. The paraelectric material layer may include, for example, silicon oxide and/or metal oxide having a high dielectric constant. The metal oxide included in the paraelectric material layer may include, for example, hafnium oxide, zirconium oxide, and/or aluminum oxide, but is not necessarily limited thereto.

The ferroelectric material layer and the paraelectric material layer may include the same material. The ferroelectric material layer may have ferroelectric properties, but the paraelectric material layer might not have ferroelectric properties. For example, when the ferroelectric material layer and the paraelectric material layer include hafnium oxide, the crystal structure of the hafnium oxide included in the ferroelectric material layer is different from the crystal structure of the hafnium oxide included in the paraelectric material layer.

The ferroelectric material layer may have a thickness that exhibits ferroelectric properties. The thickness of the ferroelectric material layer may be, for example, in a range of 0.5 nm to 10 nm, but is not necessarily limited thereto. Since a critical thickness at which each ferroelectric material exhibits ferroelectric properties may be different, the thickness of the ferroelectric material layer may vary depending on the ferroelectric material.

In an example, each of the first to fourth gate insulating layers 130, 230, 330, and 430 may include one ferroelectric material layer. In an example, each of the first to fourth gate insulating layers 130, 230, 330, and 430 may include a plurality of ferroelectric material layers that are spaced apart from each other. Each of the first to fourth gate insulating layers 130, 230, 330, and 430 may have a stacked structure in which a plurality of ferroelectric material layers and a plurality of paraelectric material layers are alternately stacked.

A first gate spacer 140 may be disposed on the sidewall of the first gate structure GS1. A third gate spacer 340 may be disposed on the sidewall of the third gate structure GS3. The second gate spacer and the fourth gate spacer may be disposed on the sidewall of the second gate structure GS2 and the sidewall of the fourth gate structure GS4, respectively.

For example, the first gate spacer 140 might not be disposed between the first lower pattern BP1 and the first sheet pattern NS1, and might not be disposed between the first sheet patterns NS1 adjacent in the third direction D3. The third gate spacer 340 might not be disposed between the third lower pattern BP3 and the third sheet pattern NS3, and might not be disposed between the third sheet patterns NS3 adjacent in the third direction D3.

The first and third gate spacers 140 and 340 may include, for example, silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC) or a combination thereof. Although the first and third gate spacers 140 and 340 are illustrated as being a single layer, this is for simplicity of description, and the present disclosure is not necessarily limited thereto.

A first gate capping pattern 145 may be disposed on the first gate structure GS1 and the second gate structure GS2. The first gate capping pattern 145 is disposed on the upper surface 120US of the first gate electrode and the upper surface of the second gate electrode 220. The upper surface 145US of the first gate capping pattern may be on the same plane as the upper surface GCS_US of the gate isolation structure.

The second gate capping pattern 345 may be disposed on the third gate structure GS3 and the fourth gate structure GS4. The second gate capping pattern 345 is disposed on the upper surface 320US of the third gate electrode and the upper surface of the fourth gate electrode 420. The upper surface 345US of the second gate capping pattern may be on the same plane as the upper surface GCS_US of the gate isolation structure.

In the cross-sectional view of FIG. 4, the first gate capping pattern 145 may be disposed on the first channel isolation structure CCW1. The first gate capping pattern 145 may be disposed on the upper surface CCW1_US of the first channel isolation structure. The second gate capping pattern 345 may be disposed on the second channel isolation structure CCW2. The second gate capping pattern 345 may be disposed on the upper surface CCW2_US of the second channel isolation structure. With respect to the bottom surface 105BS of the field insulating layer, the upper surface CCW1_US of the first channel isolation structure may be lower than the upper surface GCS_US of the gate isolation structure. With respect to the bottom surface 105BS of the field insulating layer, the upper surface CCW2_US of the second channel isolation structure may be lower than the upper surface GCS_US of the gate isolation structure.

The first gate capping pattern 145 and the second gate capping pattern 345 may include, for example, silicon nitride (SiN), silicon oxynitride (SiON), silicon carbonitride (SiCN), silicon oxycarbonitride (SiOCN), or a combination thereof.

The first source/drain pattern 150 may be disposed on the first lower pattern BP1. The first source/drain pattern 150 is disposed adjacent to the first gate structure GS 1 in the first direction D1. The first source/drain pattern 150 may be disposed between the first channel isolation structure CCW1 and the gate isolation structure GCS. The first source/drain pattern 150 is connected to the first channel pattern CH1. The first source/drain pattern 150 may be in contact with the first channel pattern CH1. The first source/drain patterns 150 may be in contact with each of the first sheet patterns NS1. For example, the first source/drain pattern 150 may be in contact with the first inner gate structure INT_GS1.

The second source/drain pattern 250 may be disposed on the second lower pattern BP2. The second source/drain pattern 250 is disposed adjacent to the second gate structure GS2 in the first direction D1. The second source/drain pattern 250 may be disposed between the first channel isolation structure CCW1 and the gate isolation structure GCS. The second source/drain pattern 250 is connected to the second channel pattern CH2. The second source/drain pattern 250 may be in contact with the second channel pattern CH2.

The third source/drain pattern 350 may be disposed on the third lower pattern BP3. The third source/drain pattern 350 is disposed adjacent to the third gate structure GS3 in the first direction D1. The third source/drain pattern 350 may be disposed between the second channel isolation structure CCW2 and the gate isolation structure GCS. The third source/drain pattern 350 is connected to the third channel pattern CH3. The third source/drain pattern 350 may be in contact with the third channel pattern CH3. The third source/drain pattern 350 may be in contact with each of the third sheet patterns NS3. For example, the third source/drain pattern 350 may be in contact with the third inner gate structure INT_GS3.

The fourth source/drain pattern 450 may be disposed on the fourth lower pattern BP4. The fourth source/drain pattern 450 is disposed adjacent to the fourth gate structure GS4 in the first direction D1. The fourth source/drain pattern 450 may be disposed between the second channel isolation structure CCW2 and the gate isolation structure GCS. The fourth source/drain pattern 450 is connected to the fourth channel pattern CH4. The fourth source/drain pattern 450 may be in contact with the fourth channel pattern CH4.

The first channel isolation structure CCW1 may be disposed between the first source/drain pattern 150 and the second source/drain pattern 250. The first source/drain pattern 150 and the second source/drain pattern 250 are spaced apart from each other in the second direction D2.

The first source/drain pattern 150 and the second source/drain pattern 250 may be in contact with the first channel isolation structure CCW1. For example, the first source/drain pattern 150 and the second source/drain pattern 250 may be in contact with the sidewall of the first channel isolation structure CCW1.

For example, a part of the first source/drain pattern 150 may overlap the first channel isolation structure CCW1 in the third direction D3. The first source/drain pattern 150 may include an overlapping portion 150_OVR overlapping the first channel isolation structure CCW1 in the third direction D3. A part of the first source/drain pattern 150 may be disposed across the first channel isolation structure CCW1. A part of the second source/drain pattern 250 may overlap the first channel isolation structure CCW1 in the third direction D3. A part of the second source/drain pattern 250 may be disposed across the first channel isolation structure CCW1.

The second channel isolation structure CCW2 may be disposed between the third source/drain pattern 350 and the fourth source/drain pattern 450. The third source/drain pattern 350 and the fourth source/drain pattern 450 are spaced apart from each other in the second direction D2.

The third source/drain pattern 350 and the fourth source/drain pattern 450 may be in contact with the second channel isolation structure CCW2. For example, the third source/drain pattern 350 and the fourth source/drain pattern 450 may be in contact with the sidewall of the second channel isolation structure CCW2.

For example, a part of the third source/drain pattern 350 and a part of the fourth source/drain pattern 450 may overlap the second channel isolation structure CCW2 in the third direction D3. A part of the third source/drain pattern 350 and a part of the fourth source/drain pattern 450 may be disposed across the second channel isolation structure CCW2.

In the semiconductor device, according to embodiments of the present disclosure, the first source/drain pattern 150 may be in contact with the first sheet pattern NS1 and the first lower pattern BP1. The third source/drain pattern 350 may be in contact with the third sheet pattern NS3 and the third lower pattern BP3.

The source/drain patterns 150, 250, 350, and 450 may be disposed on the first surface 100US of the substrate. The first source/drain pattern 150 may be included in a source/drain of a transistor using the first sheet pattern NS 1 as a channel region. The second source/drain pattern 250 may be included in a source/drain of a transistor using the second sheet pattern NS2 as a channel region. The third source/drain pattern 350 may be included in a source/drain of a transistor using the third sheet pattern NS3 as a channel region. The fourth source/drain pattern 450 may be included in a source/drain of a transistor using the fourth sheet pattern NS4 as a channel region.

Each of the first to fourth source/drain patterns 150, 250, 350, and 450 may include an epitaxial pattern. Each of the first to fourth source/drain patterns 150, 250, 350, and 450 may include a semiconductor material.

The first source/drain pattern 150 and the second source/drain pattern 250 may include dopants of the same conductivity type. The first source/drain pattern 150 and the second source/drain pattern 250 may include a p-type dopant or an n-type dopant. The third source/drain pattern 350 and the fourth source/drain pattern 450 may include dopants of the same conductivity type. The third source/drain pattern 350 and the fourth source/drain pattern 450 may include a p-type dopant or an n-type dopant. The p-type dopant may include boron (B) and/or gallium (Ga), but the present disclosure is not necessarily limited thereto. The n-type dopant may include phosphorus (P), arsenic (As), antimony (Sb), and/or bismuth (Bi), but the present disclosure is not necessarily limited thereto.

A height H14 from the bottom surface 105BS of the field insulating layer to the upper surface of the first channel pattern CH1 is smaller than a height H16 from the bottom surface 105BS of the field insulating layer 105 to the uppermost portion of the first source/drain pattern 150. Here, the uppermost portion of the first source/drain pattern 150 may be included in the structure including the first source/drain pattern 150 and a first contact silicide layer 155. The uppermost portion of the first source/drain pattern 150 may be a portion farthest from the bottom surface 105BS of the field insulating layer 105.

The following description will focus on the first channel isolation structure CCW1. For example, the description of the first channel isolation structure CCW1 may be applied to the second channel isolation structure CCW2.

In FIGS. 1, 4, 5, and 7 to 9, the first channel isolation structure CCW1 includes a first region CCW1_R1 and a second region CCW1_R2. The first region CCW1_R1 of the first channel isolation structure may be a region in contact with the first gate structure GS1 and the second gate structure GS2 in the first channel isolation structure CCW1. The first region CCW1_R1 of the first channel isolation structure may be a region overlapping the first gate structure GS1 and the second gate structure GS2 in the second direction D2. The second region CCW1_R2 of the first channel isolation structure may be a region in contact with the first source/drain pattern 150 and the second source/drain pattern 250 in the first channel isolation structure CCW1. The second region CCW1_R2 of the first channel isolation structure may be a region overlapping the first source/drain pattern 150 and the second source/drain pattern 250 in the second direction D2.

For example, FIG. 8 is a diagram illustrating the shape of the first region CCW1_R1 of the first channel isolation structure, and FIG. 9 is a diagram illustrating the shape of the second region CCW1_R2 of the first channel isolation structure.

In FIGS. 4 and 8, the width of the first channel isolation structure CCW1 in the second direction D2 may continuously increase as the distance from the bottom surface 105BS of the field insulating layer increases.

In FIGS. 5 and 9, the second region CCW1_R2 of the first channel isolation structure may include a first portion CCW1_R21 and a second portion CCW1_R22 whose widths increase as the distance from the bottom surface 105BS of the field insulating layer increases. In the first portion CCW1_R21 of the second region of the first channel isolation structure and the second portion CCW1_R22 of the second region of the first channel isolation structure, the width of the first channel isolation structure CCW1 in the second direction D2 may continuously increase as the distance from the bottom surface 105BS of the field insulating layer increases.

The second portion CCW1_R22 of the second region of the first channel isolation structure may be disposed on the first portion CCW1_R21 of the second region of the first channel isolation structure. In the semiconductor device, according to embodiments of the present disclosure, the second portion CCW1_R22 of the second region of the first channel isolation structure may be directly connected to the first portion CCW1_R21 of the second region of the first channel isolation structure.

There may be a stepped portion disposed between the first portion CCW1_R21 of the second region of the first channel isolation structure and the second portion CCW1_R22 of the second region of the first channel isolation structure. For example, a width W21 of the uppermost portion of the first channel isolation structure CCW1 in the first portion CCW1_R21 of the second region of the first channel isolation structure is greater than a width W22 of the lowermost portion of the first channel isolation structure CCW1 in the second portion CCW1_R22 of the second region of the first channel isolation structure.

Fig. 9 shows the first portion CCW1_R21 of the second region of the first channel isolation structure having a notional first width center line WCL1 extending primarily in the third direction D3. Fig. 9 also shows the second portion CCW1_R22 of the second region of the first channel isolation structure having a notional second width center line WCL2 extending primarily in the third direction D3. In the semiconductor device, according to embodiments of the present disclosure, the first width center line WCL1 may be aligned with the second width center line WCL2 in the third direction D3. For example, the extension line of the first width center line WCL1 may coincide with the second width center line WCL2.

For example, the first width center line WCL1 may be an imaginary line dividing in half the width W21 of the uppermost portion of the first portion CCW1_R21 of the second region of the first channel isolation structure. The second width center line WCL2 may be an imaginary line dividing in half the width W22 of the lowermost portion of the second portion CCW1_R22 of the second region of the first channel isolation structure.

A height H15 from the bottom surface 105BS of the field insulating layer to the uppermost portion of the first portion CCW1_R21 of the second region of the first channel isolation structure is smaller than a height H16 from the bottom surface 105BS of the field insulating layer to the uppermost portion of the first source/drain pattern 150.

A part of the first source/drain pattern 150 may overlap the first portion CCW1_R21 of the second region of the first channel isolation structure in the third direction D3. The overlapping portion 150_OVR of the first source/drain pattern may overlap the first portion CCW1_R21 of the second region of the first channel isolation structure in the third direction D3. The overlapping portion 150_OVR of the first source/drain pattern may be disposed across the first portion CCW1_R21 of the second region of the first channel isolation structure.

A part of the second source/drain pattern 250 may overlap the first portion CCW1_R21 of the second region of the first channel isolation structure in the third direction D3. A part of the second source/drain pattern 250 may be disposed across the first portion CCW1_R21 of the second region of the first channel isolation structure.

Although it is illustrated that there is no boundary surface between the first portion CCW1_R21 of the second region of the first channel isolation structure and the second portion CCW1_R22 of the second region of the first channel isolation structure, the present disclosure is not necessarily limited thereto. For example, the first portion CCW1_R21 of the second region of the first channel isolation structure may be distinguished from the second portion CCW1_R22 of the second region of the first channel isolation structure by the boundary surface.

In FIGS. 4 and 5, the height H15 from the bottom surface 105BS of the field insulating layer to the uppermost portion of the first portion CCW1_R21 of the second region of the first channel isolation structure is smaller than the height H14 from the bottom surface 105BS of the field insulating layer to the upper surface of the first channel pattern CH1.

In the cross-sectional view of FIG. 5, the upper surface CCW1_US of the first channel isolation structure may be on the same plane as the upper surface GCS_US of the gate isolation structure.

The upper surface CCW1_US of the first channel isolation structure in the first region CCW1_R1 of the first channel isolation structure may be lower than the upper surface CCW1_US of the first channel isolation structure in the second region CCW1_R2 of the first channel isolation structure. The height from the bottom surface 105BS of the field insulating layer to the upper surface CCW1_US of the first channel isolation structure in the first region CCW1_R1 of the first channel isolation structure may be lower than the height from the bottom surface 105BS of the field insulating layer to the upper surface CCW1_US of the first channel isolation structure in the second region CCW1_R2 of the first channel isolation structure.

For example, FIG. 7 is a plan view that may be taken at the height level of the second portion CCW1_R22 of the second region of the first channel isolation structure.

In FIG. 7, the width W11 of the first channel isolation structure CCW1 in the second direction D2 between the first gate structure GS1 and the second gate structure GS2 is different from the width W12 of the first channel isolation structure CCW1 in the second direction D2 between the first sour/drain pattern 150 and the second source/drain pattern 250. For example, the width W11 of the first channel isolation structure CCW1 in the second direction D2 between the first gate structure GS1 and the second gate structure GS2 is greater than the width 12 of the first channel isolation structure CCW1 in the second direction D2 between the first source/drain pattern 150 and the second source/drain pattern 250.

The first source/drain pattern 150 may overlap the first channel isolation structure CCW1 in the first direction D1 by a first overlapping width W13. The second source/drain pattern 250 may overlap the first channel isolation structure CCW1 in the first direction D1 by a second overlapping width W14. For example, the first overlapping width W13 may be the same as the second overlapping width W14.

A source/drain etch supper layer 185 may extend primarily along the outer walls of the first and third gate spacers 140 and 340, and the sidewalls of the source/drain patterns 150, 250, 350, and 450. The source/drain etch stop layer 185 may extend primarily along the upper surface 105US of the field insulating layer. For example, the source/drain etch stop layer 185 may be in contact with the sidewalls of the first to fourth source/drain patterns 150, 250, 350, and 450.

A part of the source/drain etch stop layer 185 may extend primarily along the sidewall of the first channel isolation structure CCW1 and the sidewall of the second channel isolation structure CCW2. The source/drain etch stop layer 185 on the sidewall of the first channel isolation structure CCW1 and the sidewall of the second channel isolation structure CCW2 may be a portion that remains without being removed in the process of fabricating the source/drain contacts 180, 280, 380, and 480.

As shown in Fig. 3, the source/drain etch stop layer 185 might not extend primarily along the sidewall of the first gate capping pattern 145 and the sidewall of the second gate capping pattern 345. Unlike the illustrated example, however, the source/drain etch stop layer 185 may extend primarily along the sidewall of the first gate capping pattern 145 and the sidewall of the second gate capping pattern 345.

The source/drain etch stop layer 185 may include, for example, silicon nitride (SiN), silicon oxynitride (SiON), silicon oxycarbonitride (SiOCN), silicon boron nitride (SiBN), silicon oxyboron nitride (SiOBN), silicon oxycarbide (SiOC), or a combination thereof

When the source/drain etch stop layer 185 includes the same material as that of the first channel isolation structure CCW1, the boundary between the source/drain etch stop layer 185 and the first channel isolation structure CCW1 might not be distinguished (i.e., there might be no perceivable boundary). When the source/drain etch stop layer 185 includes the same material as that of the second channel isolation structure CCW2, the boundary between the source/drain etch stop layer 185 and the second channel isolation structure CCW2 might not be distinguished (i.e., there might be no perceivable boundary). In this case, the source/drain etch stop layer 185 disposed on the source/drain patterns 150, 250, 350, and 450 and in contact with the source/drain contacts 180, 280, 380, and 480 may be recognized as a part of the first channel isolation structure CCW1 and/or the second channel isolation structure CCW2.

Unlike the illustrated example, the source/drain etch stop layer 185 might not be formed, or may be completely removed during etching.

The upper interlayer insulating layer 190 is disposed on the first surface 100US of the substrate. The upper interlayer insulating layer 190 may be disposed on the source/drain etch stop layer 185. The upper interlayer insulating layer 190 may be disposed on the first to fourth source/drain patterns 150, 250, 350, and 450.

The upper interlayer insulating layer 190 may include, for example, silicon oxide, silicon nitride, silicon oxynitride, and/or a low dielectric constant material. The dielectric constant of the low dielectric constant material may have a value smaller than 3.9 that is the dielectric constant of silicon oxide.

The first source/drain contact 180 may be disposed on the first source/drain pattern 150. The first source/drain contact 180 is electrically connected to the first source/drain pattern 150. The first source/drain contact 180 is disposed between the first channel isolation structure CCW1 and the gate isolation structure GCS. The first source/drain contact 180 may be disposed on the upper interlayer insulating layer 190. A part of the source/drain etch stop layer 185 may be disposed between the first source/drain contact 180 and the first channel isolation structure CCW1.

The second source/drain contact 280 may be disposed on the second source/drain pattern 250. The second source/drain contact 280 is electrically connected to the second source/drain pattern 250. The second source/drain contact 280 is disposed between the first channel isolation structure CCW1 and the gate isolation structure GCS. The second source/drain contact 280 may be disposed on the upper interlayer insulating layer 190. A part of the source/drain etch stop layer 185 may be disposed between the second source/drain contact 280 and the first channel isolation structure CCW1.

The third source/drain contact 380 may be disposed on the third source/drain pattern 350. The third source/drain contact 380 is electrically connected to the third source/drain pattern 350. The fourth source/drain contact 480 may be disposed on the fourth source/drain pattern 450. The fourth source/drain contact 480 is electrically connected to the fourth source/drain pattern 450.

The first contact silicide layer 155 may be disposed between the first source/drain contact 180 and the first source/drain pattern 150. A second contact silicide layer 255 may be disposed between the second source/drain contact 280 and the second source/drain pattern 250. A third contact silicide layer 355 may be disposed between the third source/drain contact 380 and the third source/drain pattern 350. A fourth contact silicide layer 455 may be disposed between the fourth source/drain contact 480 and the fourth source/drain pattern 450.

Although it is illustrated that the source/drain contacts 180, 280, 380, and 480 have a single conductive layer structure, the present disclosure is not necessarily limited thereto. Unlike the illustrated example, the source/drain contacts 180, 280, 380, and 480 may have a multi-conductive layer structure including a barrier layer and a plug layer. The source/drain contacts 180, 280, 380, and 480 may include, for example, a metal, an electrically conductive metal nitride, a conductive metal carbide, a conductive metal oxide, a conductive metal carbonitride, and/or a two-dimensional (2D) material. The contact silicide layers 155, 255, 355, and 455 may include a metal silicide material.

The 2D materials may include a 2D allotrope or a 2D compound, and may include, for example, graphene, boron nitride (BN), molybdenum sulfide, molybdenum selenide, tungsten sulfide, tungsten selenide, and/or tantalum sulfide, but the present disclosure is not necessarily limited thereto. For example, since the above-mentioned 2D materials are merely examples, the 2D materials that may be included in the semiconductor device of the present disclosure are not necessarily limited thereto.

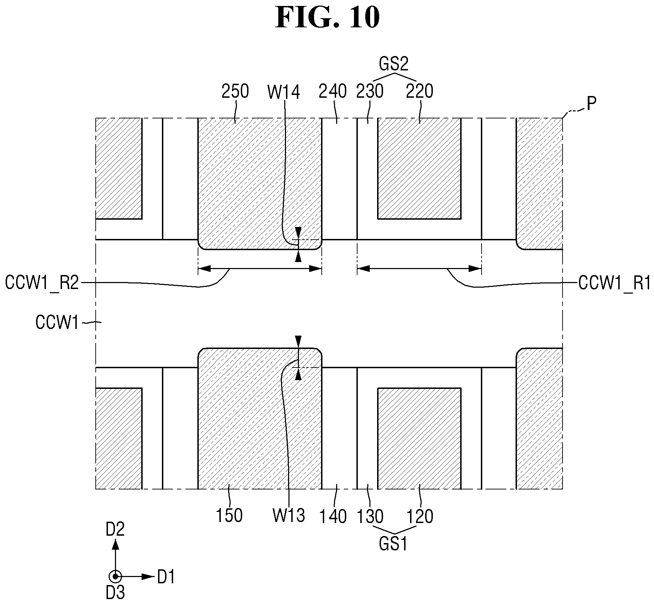

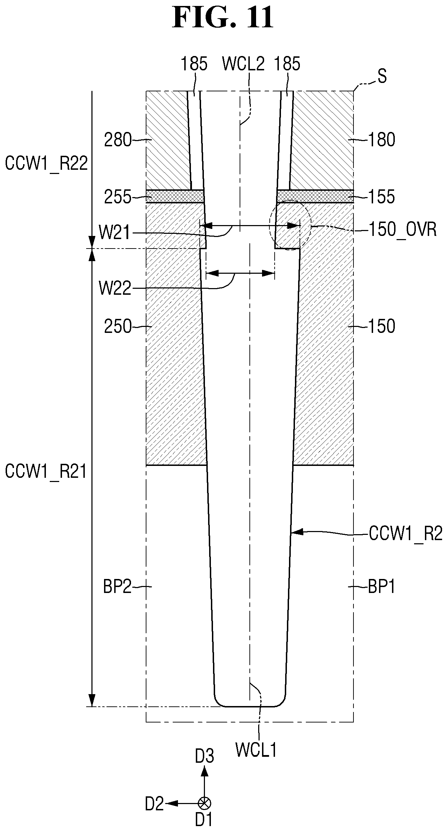

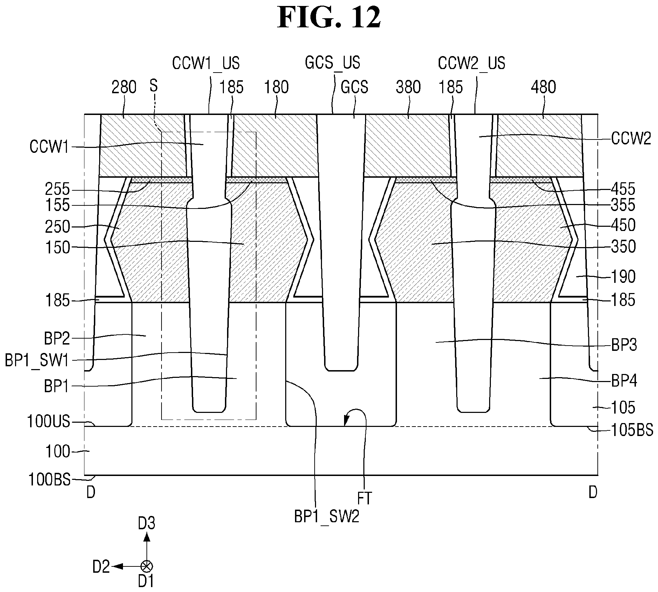

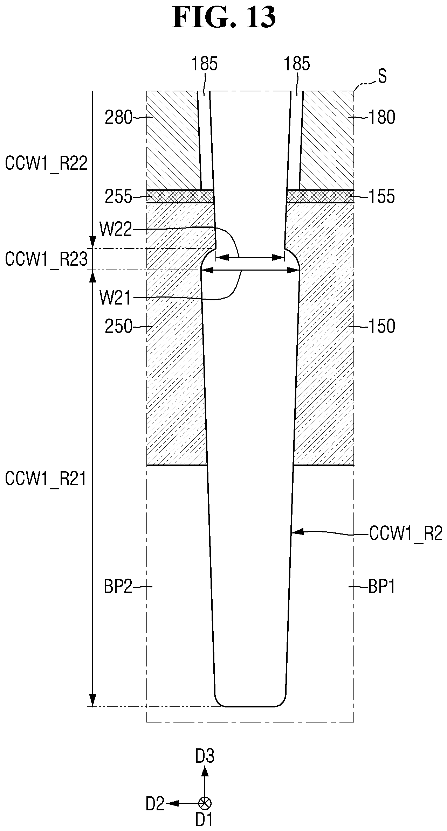

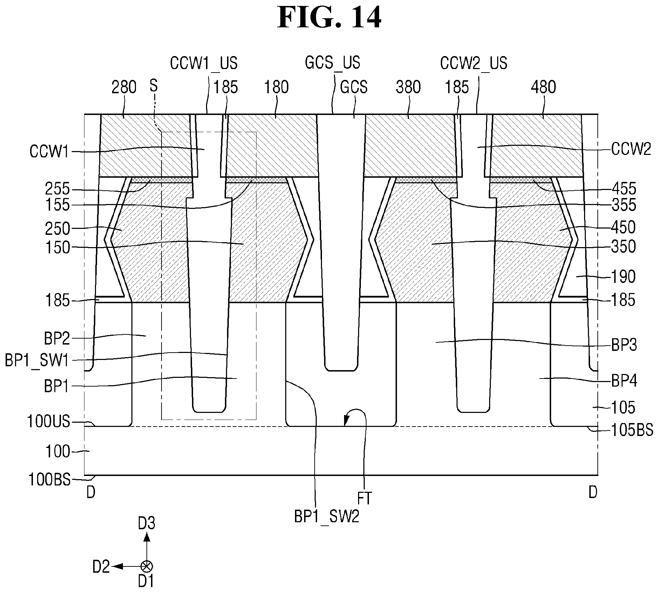

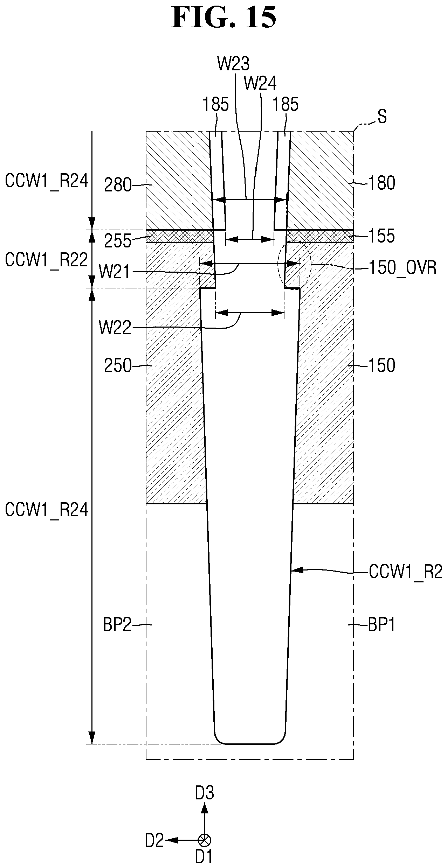

FIGS. 10 and 11 are diagrams illustrating a semiconductor device according to embodiments of the present disclosure. FIGS. 12 and 13 are diagrams illustrating a semiconductor device according to embodiments of the present disclosure. FIGS. 14 and 15 are diagrams illustrating a semiconductor device according to embodiments of the present disclosure. For simplicity of description, the following description will focus on differences from the description with reference to FIGS. 1 to 9.

FIG. 10 is a schematic plan view of part P of FIG. 1. FIG. 11 is an enlarged view of part S of FIG. 5. FIGS. 13 and 15 are enlarged views of part S of FIGS. 12 and 14.

Referring to FIGS. 10 and 11, in the semiconductor device, according to embodiments of the present disclosure, the first overlapping width W13 may be different from the second overlapping width W14.

For example, the width W13 in which the first source/drain pattern 150 overlaps the first channel isolation structure CCW1 in the first direction D1 may be greater than the width W14 in which the second source/drain pattern 250 overlaps the first channel isolation structure CCW1 in the first direction D1.

The first width center line WCL1 may be spaced apart from the second width center line WCL2 in the second direction D2. The first width center line WCL1 may be misaligned with the second width center line WCL2 in the third direction D3. The extension line of the first width center line WCL1 might not meet the second width center line WCL2.

Although it is illustrated that a part of the second source/drain pattern 250 overlaps the first portion CCW1_R21 of the second region of the first channel isolation structure in the third direction D3, the present disclosure is not necessarily limited thereto. For example, the second source/drain pattern 250 might not include a portion disposed across the first portion CCW1_R21 of the second region of the first channel isolation structure.

Referring to FIGS. 12 and 13, in the semiconductor device, according to embodiments of the present disclosure, the second region CCW1_R2 of the first channel isolation structure may further include a third portion CCW1_R23 disposed between the first portion CCW1_R21 of the second region of the first channel isolation structure and the second portion CCW1_R22 of the second region of the first channel isolation structure.

In the third portion CCW1_R23 of the second region of the first channel isolation structure, the width of the first channel isolation structure CCW1 in the second direction D2 may decrease as the distance from the bottom surface 105BS of the field insulating layer increases.

Although it is illustrated that there is no boundary surface between the first portion CCW1_R21 of the second region of the first channel isolation structure and the third portion CCW1_R23 of the second region of the first channel isolation structure, the present disclosure is not necessarily limited thereto. For example, the first portion CCW1_R21 of the second region of the first channel isolation structure may be distinguished from the third portion CCW1_R23 of the second region of the first channel isolation structure by the boundary surface.

Referring to FIGS. 14 and 15, in the semiconductor device, according to embodiments of the present disclosure, the second region CCW1_R2 of the first channel isolation structure may further include a fourth portion CCW1_R24 whose width increases as the distance from the bottom surface 105BS of the field insulating layer increases.

The fourth portion CCW1_R24 of the second region of the first channel isolation structure may be disposed on the second portion CCW1_R22 of the second region of the first channel isolation structure. In the fourth portion CCW1_R24 of the second region of the first channel isolation structure, the width of the first channel isolation structure CCW1 in the second direction D2 may increase as the distance from the bottom surface 105BS of the field insulating layer increases.

For example, the second portion CCW1_R22 of the second region of the first channel isolation structure may be directly connected to the fourth portion CCW1_R24 of the second region of the first channel isolation structure. The fourth portion CCW1_R24 of the second region of the first channel isolation structure may overlap the first source/drain contact 180 and the second source/drain contact 280 in the second direction D2.

There may be a stepped portion between the fourth portion CCW1_R24 of the second region of the first channel isolation structure and the second portion CCW1_R22 of the second region of the first channel isolation structure. A width W23 of the uppermost portion of the first channel isolation structure CCW1 at the second portion CCW1_R22 of the second region of the first channel isolation structure is greater than a width W24 of the lowermost portion of the first channel isolation structure CCW1 at the fourth portion CCW1_R24 of the second region of the first channel isolation structure.

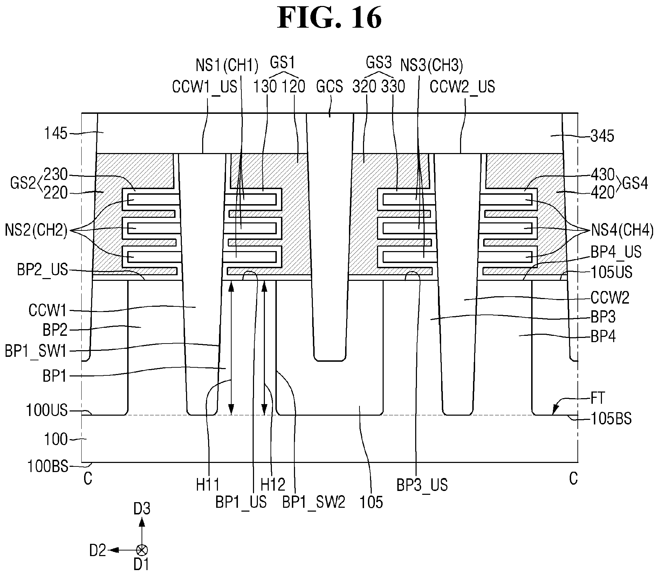

FIGS. 16 to 19 are diagrams each illustrating a semiconductor device according to embodiments of the present disclosure. For simplicity of description, the following description will focus on differences from the description with reference to FIGS. 1 to 9.

Referring to FIG. 16, in the semiconductor device, according to embodiments of the present disclosure, the depth H11 from the upper surface BP1_US of the first lower pattern to the lowermost portion of the first channel isolation structure CCW1 may be the same as the depth H12 from the upper surface BP1_US of the first lower pattern to the bottom surface 105BS of the field insulating layer.

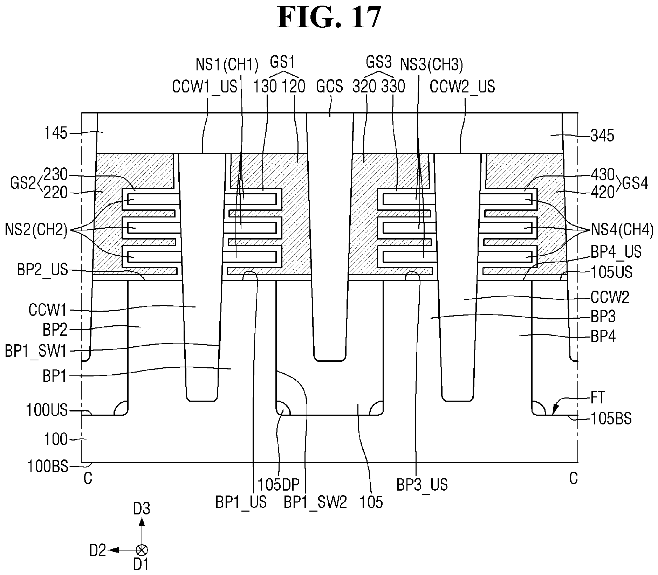

Referring to FIG. 17, the semiconductor device, according to embodiments of the present disclosure, may further include a field insulating line pattern 105DP.

The field insulating line pattern 105DP may be disposed at the boundary portion, between the bottom surface of the fin trench FT and the sidewall of the fin trench FT. The field insulating line pattern 105DP may extend primarily in the first direction D1 along the fin trench FT. The field insulating layer 105 is disposed on the field insulating line pattern 105DP.

The field insulating line pattern 105DP includes the same material as that of the first channel isolation structure CCW1 and the second channel isolation structure CCW2. In a fabricating process, the field insulating line pattern 105DP may be formed during the formation of the first channel isolation structure CCW1 and the second channel isolation structure CCW2.

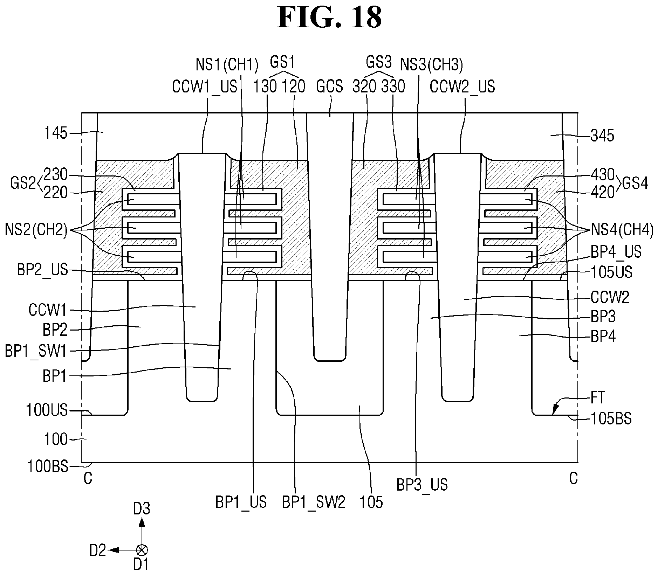

Referring to FIG. 18, in the semiconductor device, according to embodiments of the present disclosure, the first gate capping pattern 145 may cover a part of the sidewall of the first channel isolation structure CCW1.

A part of the first gate capping pattern 145 may overlap a part of the sidewall of the first channel isolation structure CCW1 in the second direction D2. In cross-sectional view, a part of the first gate capping pattern 145 may protrude more toward the first substrate 100 than the upper surface CCW1_US of the first channel isolation structure.

The second gate capping pattern 345 may cover a part of the sidewall of the second channel isolation structure CCW2.

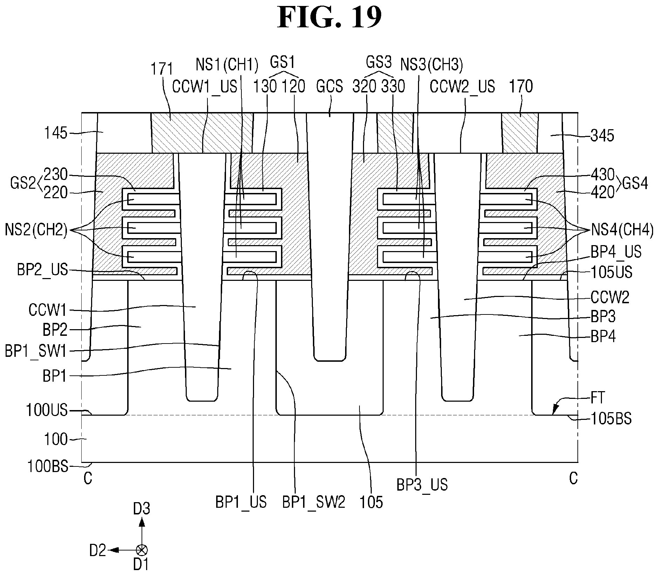

Referring to FIG. 19, the semiconductor device, according to embodiments of the present disclosure, may further include gate contacts 170 and a gate bridge contact 171.

The gate contacts 170 may be disposed in the second gate capping pattern 345. The gate contacts 170 may be connected to the third gate electrode 320 and the fourth gate electrode 420. For example, one gate contact 170 may be connected to one gate electrode 320 or 420.

The gate bridge contact 171 may be disposed in the first gate capping pattern 145. The gate bridge contact 171 is connected to the first gate electrode 120 and the second gate electrode 220. The gate bridge contact 171 connects the first gate electrode 120 and the second gate electrode 220 that are spaced apart from each other in the second direction D2. The gate bridge contact 171 serves to connect the spaced gate electrodes, and also performs the function of the gate contact 170.

Although it is illustrated that the gate contact 170 and the gate bridge contact 171 have a single conductive layer structure, the present disclosure is not necessarily limited thereto. Unlike the illustrated example, the gate contact 170 and the gate bridge contact 171 may have a multi-conductive layer structure including a barrier layer and a plug layer. The gate contact 170 and the gate bridge contact 171 may include, for example, a metal, an electrically conductive metal nitride, a conductive metal carbide, a conductive metal oxide, a conductive metal carbonitride, and/or a two-dimensional (2D) material.

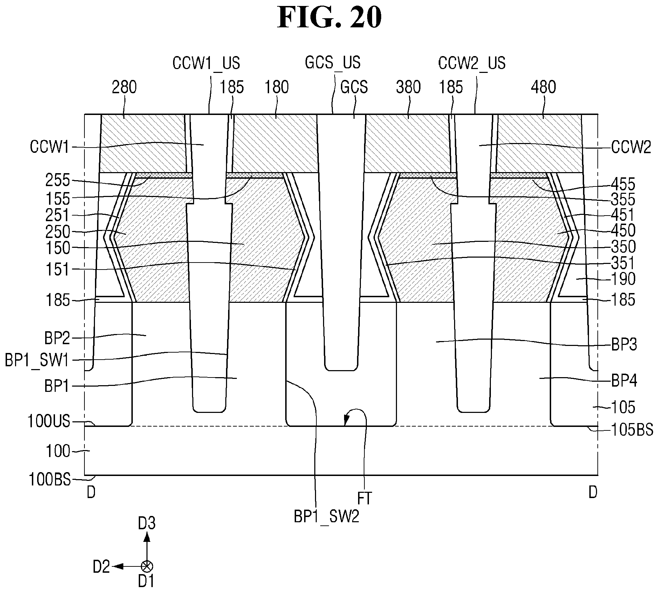

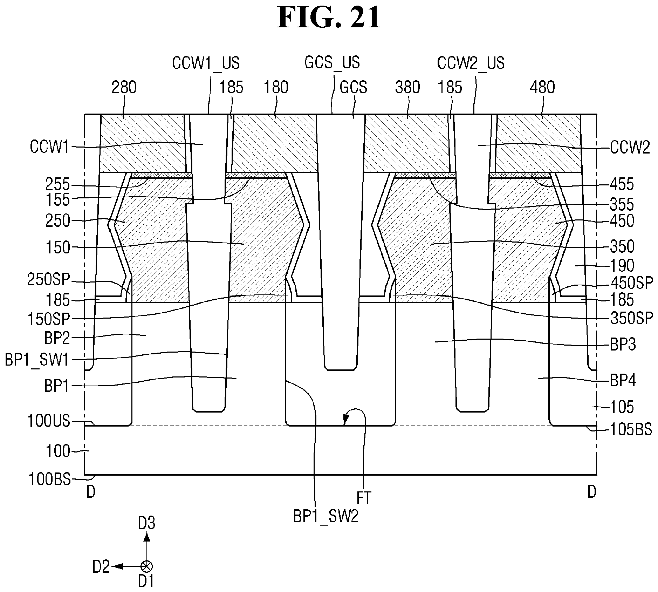

FIGS. 20 and 21 are diagrams each illustrating a semiconductor device according to embodiments of the present disclosure. For simplicity of description, the following description will focus on differences from the description with reference to FIGS. 1 to 9.

Referring to FIG. 20, the semiconductor device, according to embodiments of the present disclosure, may further include first to fourth insertion source/drain oxide layers 151, 251, 351, and 451 in contact with the first to fourth source/drain patterns 150, 250, 350, and 450.

The first insertion source/drain oxide layer 151 may be disposed between the first source/drain pattern 150 and the source/drain etch stop layer 185. The second insertion source/drain oxide layer 251 may be disposed between the second source/drain pattern 250 and the source/drain etch stop layer 185. The third insertion source/drain oxide layer 351 may be disposed between the third source/drain pattern 350 and the source/drain etch stop layer 185. The fourth insertion source/drain oxide layer 451 may be disposed between the fourth source/drain pattern 450 and the source/drain etch stop layer 185.

The first to fourth insertion source/drain oxide layers 151, 251, 351, and 451 include an oxide of a semiconductor material included in the first to fourth source/drain patterns 150, 250, 350, and 450.

Referring to FIG. 21, the semiconductor device, according to embodiments of the present disclosure, may further include first to fourth source/drain fences 150SP, 250SP, 350SP, and 450SP disposed on the upper surface 105US of the field insulating layer.

Each of the first to fourth source/drain fences 150SP, 250SP, 350SP, and 450SP may protrude from the upper surface 105US of the field insulating layer in the third direction D3. The first to fourth source/drain fences 150SP, 250SP, 350SP, and 450SP may be in contact with the first to fourth source/drain patterns 150, 250, 350, and 450, respectively.

The first source/drain fence 150SP may be disposed on a part of the sidewall of the first source/drain pattern 150. The second source/drain fence 250SP may be disposed on a part of the sidewall of the second source/drain pattern 250. The third source/drain fence 350SP may be disposed on a part of the sidewall of the third source/drain pattern 350. The fourth source/drain fence 450SP may be disposed on a part of the sidewall of the fourth source/drain pattern 450.

The first to fourth source/drain fences 150SP, 250SP, 350SP, and 450SP may include materials included in the first gate spacer 140 and the third gate spacer 340. For example, in the fabricating process, the first to fourth source/drain fences 150SP, 250SP, 350SP, and 450SP may be formed together with the first gate spacer 140 and the third gate spacer 340.

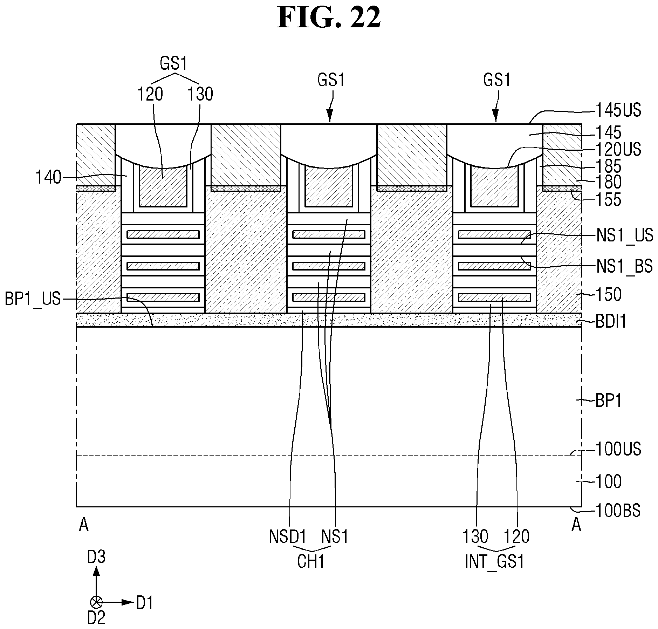

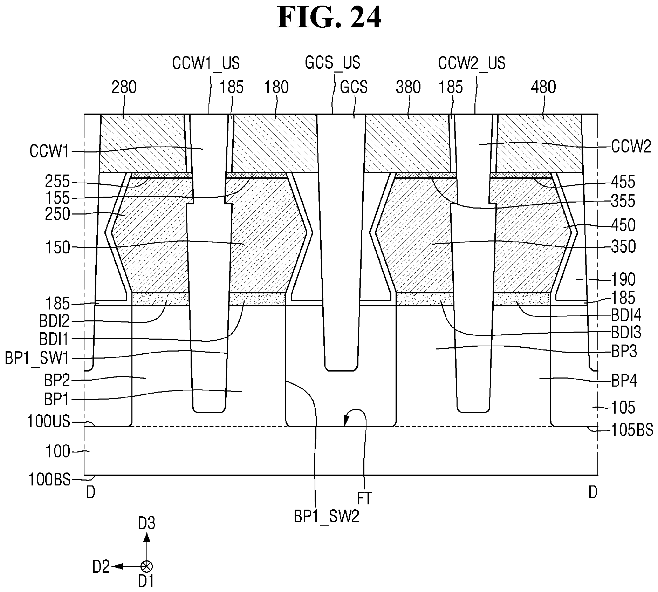

Referring to FIGS. 22 to 24 are diagrams illustrating a semiconductor device according to embodiments of the present disclosure. For simplicity of description, the following description will focus on differences from the description with reference to FIGS. 1 to 9.

FIGS. 22 to 24 are diagrams each illustrating a semiconductor device according to embodiments of the present disclosure.

Referring to FIGS. 20 to 22, the semiconductor device, according to embodiments of the present disclosure, may further include first to fourth lower insulating patterns BDI1, BDI2, BDI3, and BDI4.

The first lower insulating pattern BDI1 may be disposed between the first lower pattern BP1 and the first channel pattern CH1. The first lower insulating pattern BDI1 may be in contact with the upper surface BP1_US of the first lower pattern. The first lower insulating pattern BDI1 may extend primarily in the first direction D1 along the upper surface BP1_US of the first lower pattern.

The second lower insulating pattern BDI2 may be disposed between the second lower pattern BP2 and the second channel pattern CH2. The second lower insulating pattern BDI2 may be in contact with the upper surface BP2_US of the second lower pattern. The second lower insulating pattern BDI2 may extend primarily in the first direction D1 along the upper surface BP2_US of the second lower pattern.

The third lower insulating pattern BDI3 may be disposed between the third lower pattern BP3 and the third channel pattern CH3. The third lower insulating pattern BDI3 may be in contact with the upper surface BP3_US of the third lower pattern. The third lower insulating pattern BDI3 may extend primarily in the first direction D1 along the upper surface BP3_US of the third lower pattern.

The fourth lower insulating pattern BDI4 may be disposed between the fourth lower pattern BP4 and the fourth channel pattern CH4. The fourth lower insulating pattern BDI4 may be in contact with the upper surface BP4_US of the fourth lower pattern. The fourth lower insulating pattern BDI4 may extend primarily in the first direction D1 along the upper surface BP4_US of the fourth lower pattern.

The first lower insulating pattern BDI1 may be spaced apart from the second lower insulating pattern BDI2 in the second direction D2. The first channel isolation structure CCW1 may isolate the first lower insulating pattern BDI1 from the second lower insulating pattern BDI2.

The third lower insulating pattern BDI3 may be spaced apart from the fourth lower insulating pattern BDI4 in the second direction D2. The second channel isolation structure CCW2 may isolate the third lower insulating pattern BDI3 from the fourth lower insulating pattern BDI4.

The first to fourth lower insulating patterns BDI1, BDI2, BDI3, and BDI4 might not extend along the upper surface 105US of the field insulating layer. The first to fourth lower insulating patterns BDI1, BDI2, BDI3, and BDI4 might not cover the upper surface 105US of the field insulating layer.

The first to fourth lower insulating patterns BDI1, BDI2, BDI3, and BDI4 may include, for example, silicon nitride (SiN), silicon oxynitride (SiON), silicon carbonitride (SiCN), and/or silicon oxynitride (SiOCN). Alternatively, the first to fourth lower insulating patterns BDI1, BDI2, BDI3, and BDI4 may include silicon oxide.

The first channel pattern CH1 may further include a first dummy sheet pattern NSD1 disposed between the first sheet pattern NS1 and the first lower insulating pattern BDI1. The first dummy sheet pattern NSD1 may be in contact with the first lower insulating pattern BDI1.

The second channel pattern CH2 may further include a second dummy sheet pattern NSD2 disposed between the second sheet pattern NS2 and the second lower insulating pattern BDI2. The second dummy sheet pattern NSD2 may be in contact with the second lower insulating pattern BDI2.

The third channel pattern CH3 may further include a third dummy sheet pattern NSD3 disposed between the third sheet pattern NS3 and the third lower insulating pattern BDI3. The third dummy sheet pattern NSD3 may be in contact with the third lower insulating pattern BDI3.

The fourth channel pattern CH4 may further include a fourth dummy sheet pattern NSD4 disposed between the fourth sheet pattern NS4 and the fourth lower insulating pattern BDI4. The fourth dummy sheet pattern NSD4 may be in contact with the fourth lower insulating pattern BDI4.

The thicknesses of the dummy sheet patterns NSD1, NSD2, NSD3, and NSD4 in the third direction D3 are smaller than the thicknesses of the sheet patterns NS1, NS2, NS3, and NS4 in the third direction D3. The dummy sheet patterns NSD1, NSD2, NSD3, and NSD4 may include the same material as the sheet patterns NS1, NS2, NS3, and NS4.

Taking the first lower insulating pattern BDI1 as an example, the first lower insulating pattern BDI1 may include a upper surface and a bottom surface opposite to each other in the third direction D3. The bottom surface of the first lower insulating pattern BDI1 may be in contact with the upper surface BP1_US of the first lower pattern. The upper surface of the first lower insulating pattern BDI1 may be higher than the upper surface 105US of the field insulating layer with respect to the bottom surface 105BS of the field insulating layer. An upper surface of the first lower insulating pattern BDI1 may protrude beyond the upper surface 105US of the field insulating layer. Since the first dummy sheet pattern NSD1 is in contact with the upper surface of the first lower insulating pattern BDI1, the first gate insulating layer 130 might not be in contact with the upper surface of the first lower insulating pattern BDI1.

The first source/drain pattern 150 may be in contact with the first dummy sheet pattern NSD1 and the first sheet pattern NS1. The first source/drain pattern 150 may be in contact with the first lower insulating pattern BDI1. The first source/drain pattern 150 might not be in contact with the first lower pattern BP1.

The second source/drain pattern 250 may be in contact with the second dummy sheet pattern NSD2 and the second sheet pattern NS2. The second source/drain pattern 250 may be in contact with the second lower insulating pattern BDI2. The second source/drain pattern 250 might not be in contact with the second lower pattern BP2.

The third source/drain pattern 350 may be in contact with the third dummy sheet pattern NSD3 and the third sheet pattern NS3. The third source/drain pattern 350 may be in contact with the third lower insulating pattern BDI3. The third source/drain pattern 350 might not be in contact with the third lower pattern BP3.

The fourth source/drain pattern 450 may be in contact with the fourth dummy sheet pattern NSD4 and the fourth sheet pattern NS4. The fourth source/drain pattern 450 may be in contact with the fourth lower insulating pattern BDI4. The second source/drain pattern 250 might not be in contact with the second lower pattern BP2.

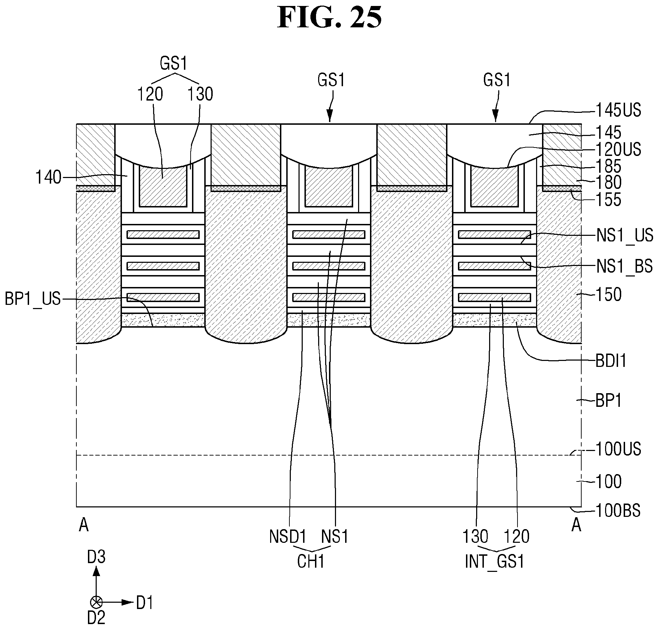

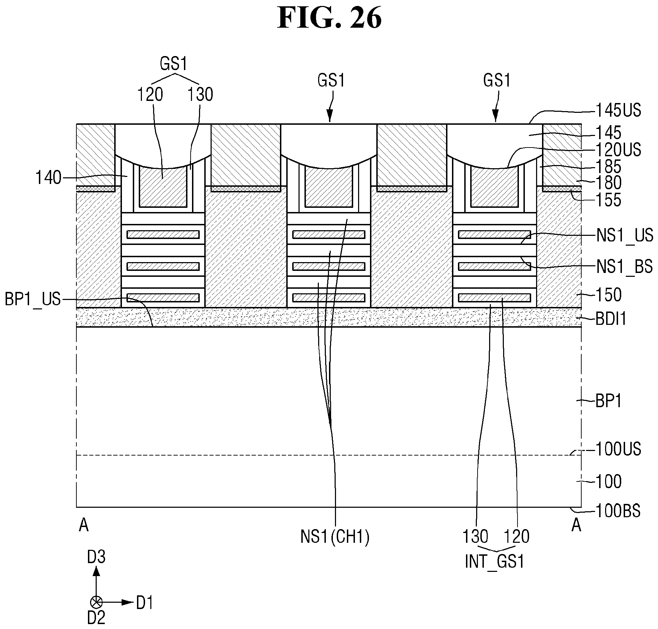

FIGS. 25 and 26 are diagrams each illustrating a semiconductor device according to embodiments of the present disclosure. For simplicity of description, the following description will focus on differences from the description with reference to FIGS. 22 to 24.

Referring to FIG. 25, in the semiconductor device, according to embodiments of the present disclosure, the first source/drain pattern 150 may penetrate the first lower insulating pattern BDI1.

The first source/drain pattern 150 may be in contact with the first lower insulating pattern BDI1 and the first lower pattern BP1.

Since the first lower insulating pattern BDI1 is isolated by the first source/drain pattern 150, a plurality of first lower insulating patterns BDI1 may be disposed on the upper surface BP1_US of the first lower pattern. The plurality of first lower insulating patterns BDI1 may be arranged in the first direction D1. Each of the first lower insulating patterns BDI1 may be disposed at a position overlapping the first gate structure GS1 in the third direction D3.

For example, information about the first source/drain pattern 150 and the first lower insulating pattern BDI1 may be applied to the second to fourth source/drain patterns 250, 350, and 450 and the second to fourth lower insulating patterns BDI2, BDI3, and BDI4. For example, information about the first source/drain pattern 150 and the first lower insulating pattern BDI1 may be applied to the second source/drain pattern 250 and the second lower insulating pattern BDI2. Information about the first source/drain pattern 150 and the first lower insulating pattern BDI1 might not apply to the third and fourth source/drain patterns 350 and 450 and the third and fourth lower insulating pattern BDI3 and BDI4.

Referring to FIG. 26, in the semiconductor device, according to embodiments of the present disclosure, the first channel pattern CH1 does not include a dummy sheet pattern disposed between the first sheet pattern NS1 and the first lower insulating pattern BDI1.

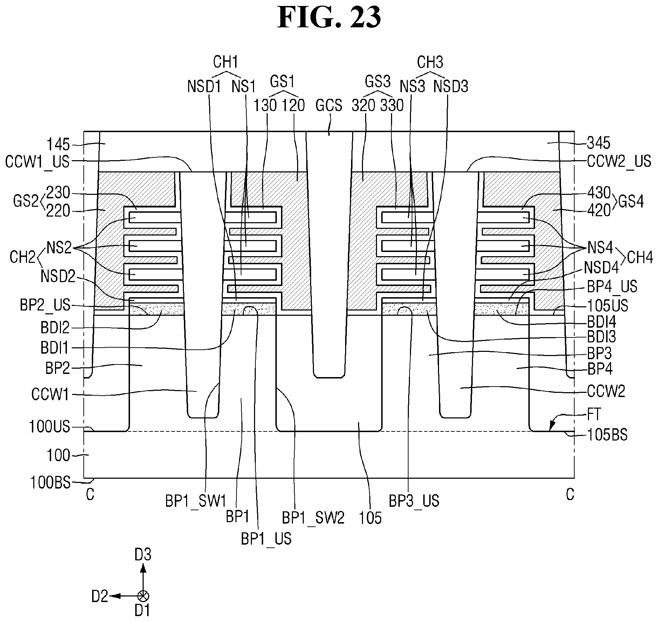

Since the first dummy sheet pattern NSD1 (see FIGS. 22 and 23) is not disposed between the first lower insulating pattern BDI1 and the first sheet pattern NS 1, the first gate insulating layer 130 may be in contact with the upper surface of the first lower insulating pattern BDI1.

The second to fourth channel patterns CH2, CH3, and CH4 do not include dummy sheet patterns.

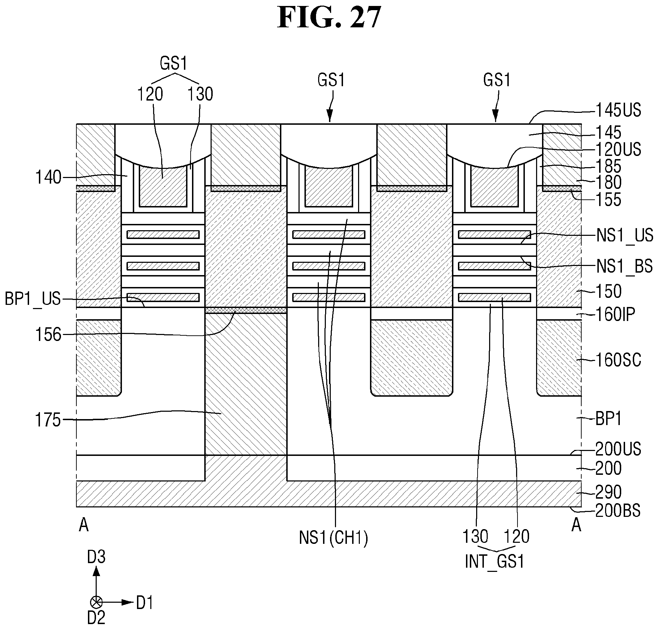

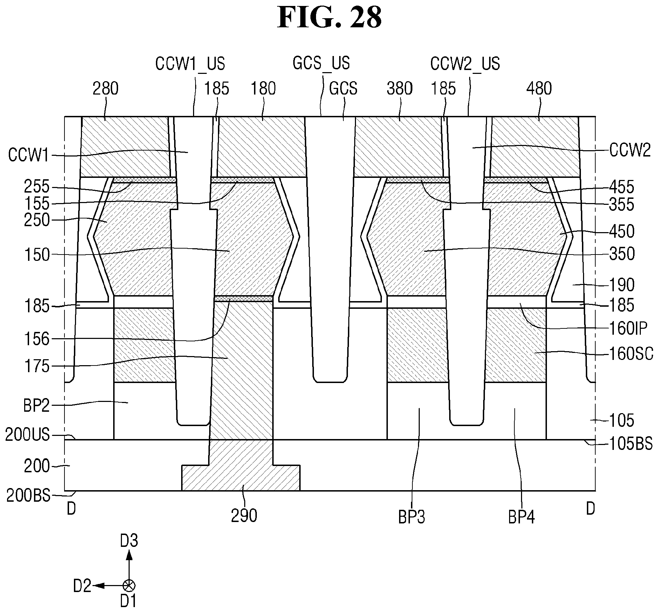

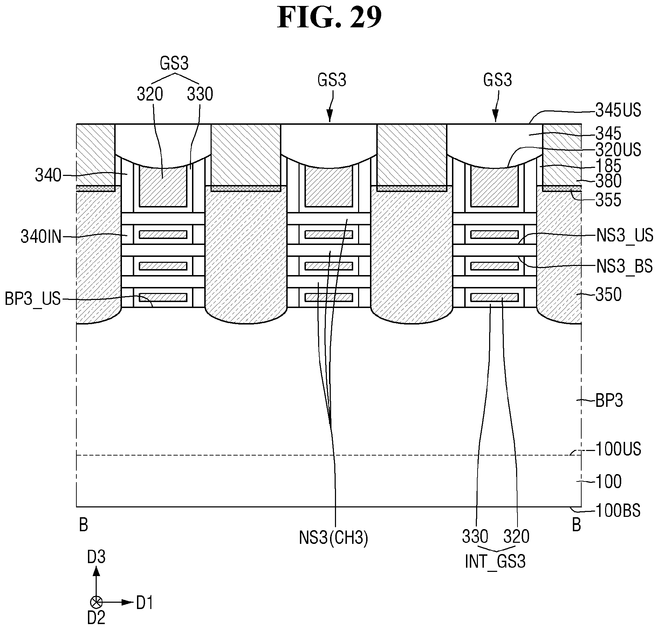

FIGS. 27 and 28 are diagrams illustrating a semiconductor device according to embodiments of the present disclosure. FIG. 29 is a diagram illustrating a semiconductor device according to embodiments of the present disclosure. For simplicity of description, the following description will focus on differences from the description with reference to FIGS. 1 to 9.

Referring to FIGS. 27 and 28, the semiconductor device, according to embodiments of the present disclosure, may further include a sacrificial semiconductor pattern 160SC, a sacrificial pattern capping layer 160IP, a back source/drain contact 175, and a back wiring line 290.

The first lower pattern BP1, the second lower pattern BP2, the third lower pattern BP3, and the fourth lower pattern BP4 may be disposed on a substrate 200. The substrate 200 may include a first surface 200US and a second surface 200BS opposite to each other in the third direction D3. The first to fourth lower patterns BP1, BP2, BP3, and BP4 are disposed on the first surface 200US of the substrate 200.

The substrate 200 may include an electrically insulating material and may include silicon oxide, silicon nitride, and/or a combination thereof. The substrate 200 may be a substrate formed by a deposition process or the like after the first substrate 100 of FIGS. 2 to 5 is removed during the fabricating process.

The field insulating layer 105 may be in contact with the substrate 200. The bottom surface 105BS of the field insulating layer faces the substrate 200.

The sacrificial semiconductor pattern 160SC may be disposed in the first to fourth lower patterns BP1, BP2, BP3, and BP4. The sacrificial semiconductor pattern 160SC may be disposed between the first to fourth source/drain patterns 150, 250, 350, and 450 and the substrate 200. The sacrificial semiconductor pattern 160SC may overlap the first to fourth source/drain patterns 150, 250, 350, and 450 in the third direction D3.

The sacrificial pattern capping layer 160IP may be disposed between the first source/drain pattern 150 and the sacrificial semiconductor pattern 160SC and between the second source/drain pattern 250 and the sacrificial semiconductor pattern 160SC. The sacrificial pattern capping layer 160IP may be disposed between the third source/drain pattern 350 and the sacrificial semiconductor pattern 160SC and between the fourth source/drain pattern 450 and the sacrificial semiconductor pattern 160SC.

The sacrificial semiconductor pattern 160SC may include a material having an etch selectivity with respect to the first to fourth lower patterns BP1, BP2, BP3, and BP4. When the first to fourth lower patterns BP1, BP2, BP3, and BP4 are silicon patterns, the sacrificial semiconductor pattern 160SC may include silicon germanium. The sacrificial pattern capping layer 160IP may include an electrically insulating material.

The back wiring line 290 may be disposed within the substrate 200. The back wiring line 290 may include a line portion and a via portion. Although the line portion of the back wiring line 290 is illustrated as extending primarily in the first direction D1, it is for simplicity of description, and is not necessarily limited thereto. The via portion of the back wiring line 290 may protrude from the line portion of the back wiring line 290 in the third direction D3. Unlike the illustrated example, the back wiring line 290 might not include a via portion.

The back source/drain contact 175 may be disposed between the first source/drain pattern 150 and the back wiring line 290. The back source/drain contact 175 electrically connects the first source/drain contact 150 to the back wiring line 290.

The back source/drain contact 175 is illustrated as being connected to a part of the first source/drain pattern 150, but it is for simplicity of description, and is not necessarily limited thereto. Unlike the illustrated example, the back source/drain contact 175 may be connected to the second to fourth source/drain patterns 250, 350, and 450.

The back contact silicide layer 156 may be disposed between the back source/drain contact 175 and the first source/drain pattern 150.

Each of the back source/drain contact 175 and the back wiring line 290 is illustrated as a single conductive layer, but is not necessarily limited thereto. Unlike the illustrated example, the back source/drain contact 175 and/or the back wiring line 290 may have a conductive multilayer structure including a barrier layer and a filling layer. Each of the back source/drain contact 175 and the back wiring line 290 may include, for example, a metal, an electrically conductive metal nitride, a conductive metal carbide, a conductive metal oxide, a conductive metal carbonitride, and/or a two-dimensional material.

Referring to FIG. 29, the semiconductor device, according to embodiments of the present disclosure, may further include an inner spacer 340IN disposed between the third source/drain pattern 350 and the third inner gate structure INT_GS3.

The inner spacer 340IN may be disposed between the third lower pattern BP3 and the third sheet pattern NS3 and between third sheet patterns NS3 adjacent in the third direction D3. The third inner gate structure INT_GS3 might not be in contact with the third source/drain pattern 350.

The inner spacer 340IN may include, for example, silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC) and/or a combination thereof.

The inner spacer may be disposed between the third lower pattern BP3 (see FIG. 3) and the third sheet pattern NS3 and between the third sheet patterns NS3 adjacent in the third direction D3.

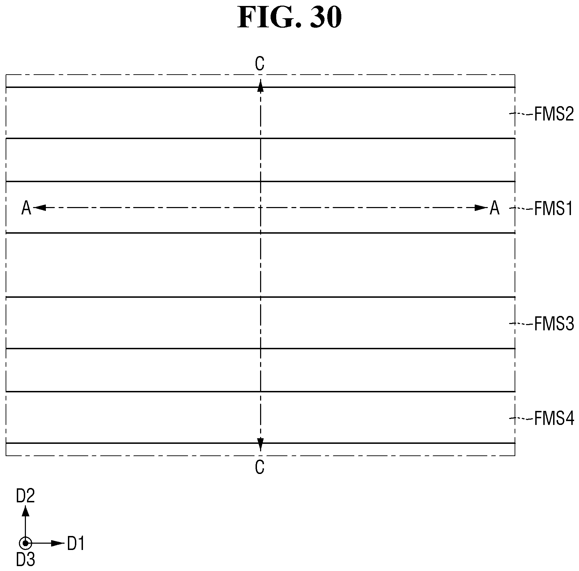

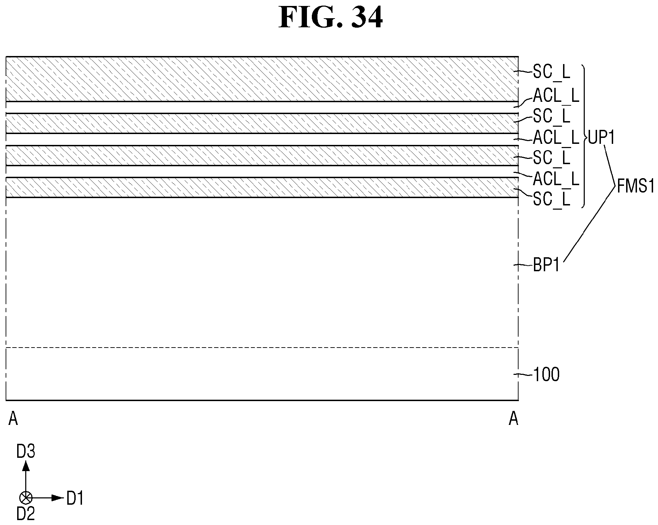

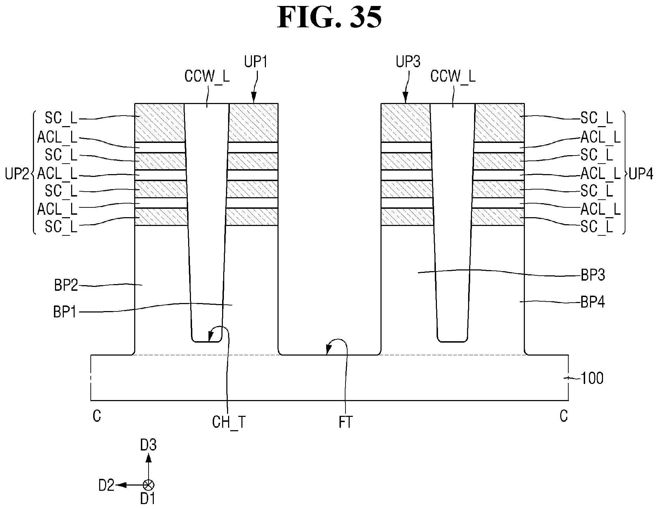

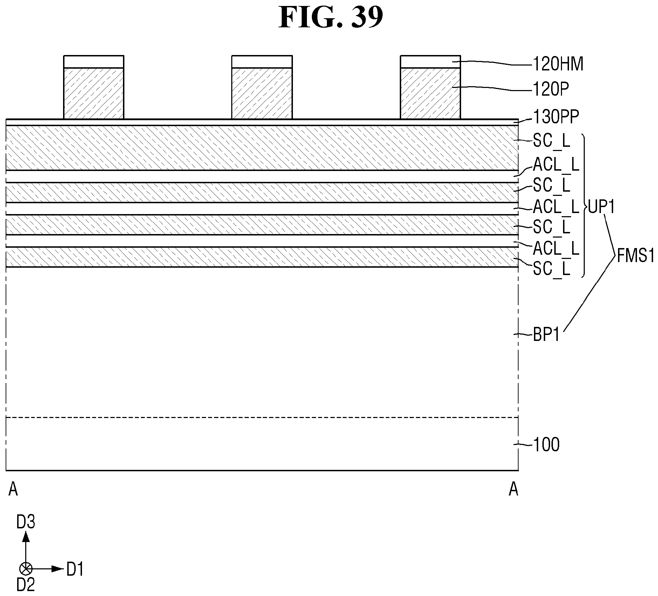

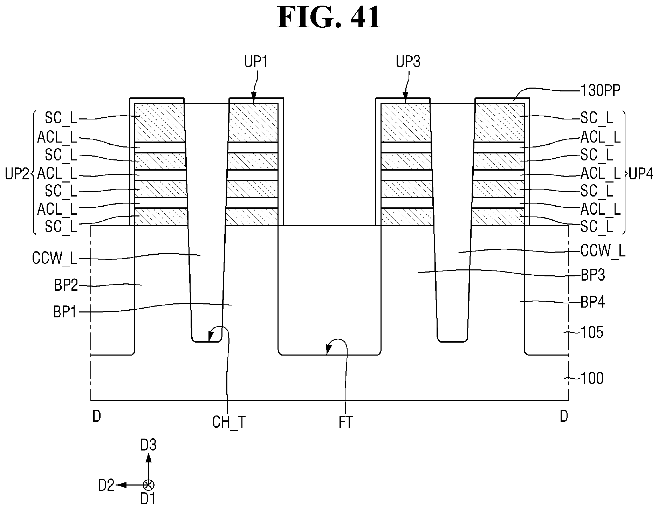

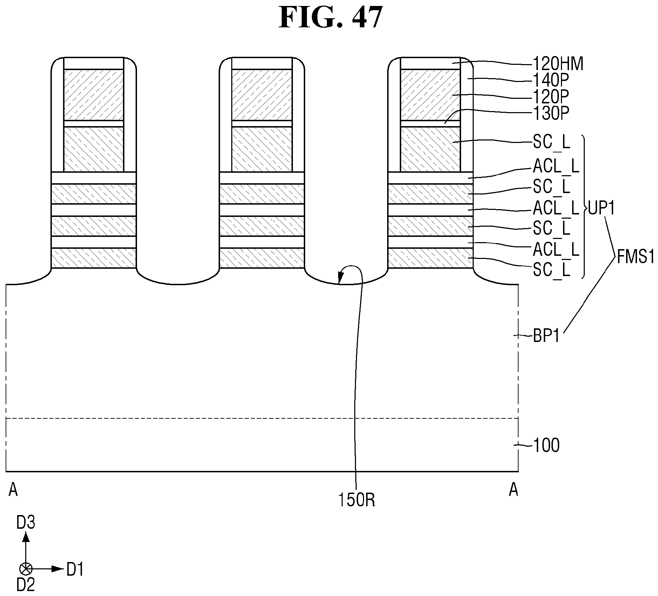

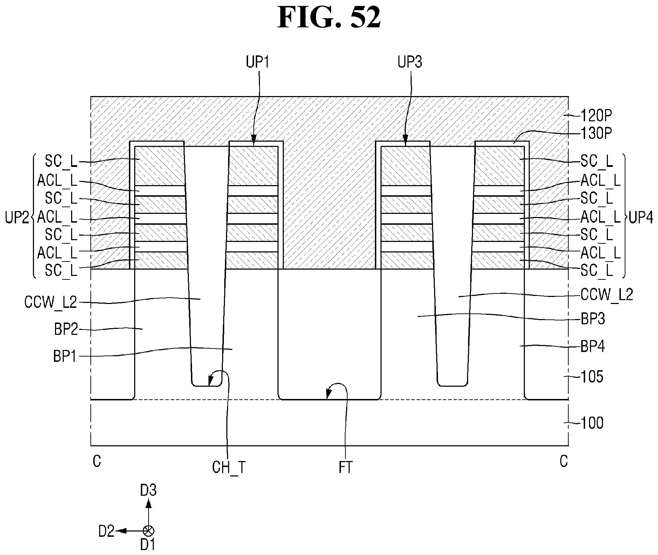

FIGS. 30 to 59 are views illustrating the intermediate steps of a method for fabricating a semiconductor device according to embodiments of the present disclosure.

Referring to FIGS. 30 to 32, first to fourth mold fin-type patterns FMS1, FMS2, FMS3, and FMS4 may be formed on the first substrate 100.

Each of the first to fourth mold fin-type patterns FMS1, FMS2, FMS3, and FMS4 may extend primarily in the first direction D1. The first to fourth mold fin-type patterns FMS1, FMS2, FMS3, and FMS4 may be spaced apart from each other in the second direction D2.

The first mold fin-type pattern FMS1 and the second mold fin-type pattern FMS2 may be isolated by a channel trench CH_T extending primarily in the first direction D1. The third mold fin-type pattern FMS3 and the fourth mold fin-type pattern FMS4 may be isolated by the channel trench CH_T extending primarily in the first direction D1. The first mold fin-type pattern FMS1 and the third mold fin-type pattern FMS3 may be isolated by the fin trench FT extending primarily in the first direction D1.

Two mold fin-type patterns may be formed between the adjacent fin trenches FT in the second direction D2. The two mold fin-type patterns formed between the fin trenches FT may be isolated by the channel trench CH_T. The bottom surface of the channel trench CH_T is illustrated to be higher than the bottom surface of the fin trench FT, but is not necessarily limited thereto. Unlike the illustrated example, the bottom surface of the channel trench CH_T may be positioned at the same height level as the bottom surface of the fin trench FT.

The first mold fin-type pattern FMS1 may include the first lower pattern BP1 and a first upper pattern structure UP 1. The second mold fin-type pattern FMS2 may include the second lower pattern BP2 and a second upper pattern structure UP2. The third mold fin-type pattern FMS3 may include the third lower pattern BP3 and a third upper pattern structure UP3. The fourth mold fin-type pattern FMS4 may include the fourth lower pattern BP4 and a fourth upper pattern structure UP4. The first to fourth upper pattern structures UP1, UP2, UP3, and UP4 are formed on the first to fourth lower patterns BP1, BP2, BP3, and BP4.

Each of the first to fourth upper pattern structures UP1, UP2, UP3, and UP4 may include a plurality of sacrificial patterns SC_L and a plurality of active patterns ACT_L that are alternately stacked. For example, the pre-active pattern ACT_L may include a silicon layer. The pre-sacrificial pattern SC_L may include a silicon-germanium layer.

In the first to fourth upper pattern structures UP1, UP2, UP3, and UP4, the sacrificial pattern SC_L may be disposed on an uppermost portion. For example, the sacrificial pattern SC_L that is disposed on an uppermost portion may be the uppermost sacrificial pattern. The thickness of the uppermost sacrificial pattern SC_L is greater than the thicknesses of the other sacrificial patterns SC_L.

A mold hard mask pattern F_HM may be disposed on each of the first to fourth mold fin-type patterns FMS1, FMS2, FMS3, and FMS4. The mold hard mask pattern F_HM may be used as a mask forming the first to fourth mold fin-type patterns FMS1, FMS2, FMS3, and FMS4. For example, the mold hard mask pattern F_HM may include silicon nitride, but is not necessarily limited thereto.

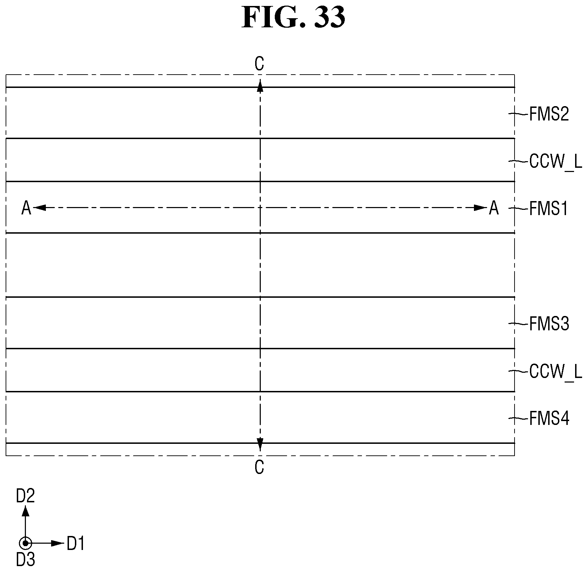

Referring to FIGS. 33 to 35, the lower channel isolation structure CCW_L is formed on the first substrate 100.

The lower channel isolation structure CCW_L is formed in the channel trench CH_T. The lower channel isolation structure CCW_L may fill the channel trench CH_T.

While the lower channel isolation structure CCW_L is formed, the mold hard mask pattern F_HM may be removed. Upper surfaces of the first to fourth upper pattern structures UP1, UP2, UP3, and UP4 may be exposed. For example, the upper surface of the lower channel isolation structure CCW_L may be on the same plane as the upper surfaces of the first to fourth mold fin-type patterns FMS1, FMS2, FMS3, and FMS4.

Since the lower channel isolation structure CCW_L is formed in the channel trench CH_T, a variation in the widths of the first to fourth sheet patterns NS1, NS2, NS3, and NS4 formed by the first to fourth upper pattern structures UP1, UP2, UP3, and UP4 may be minimized.

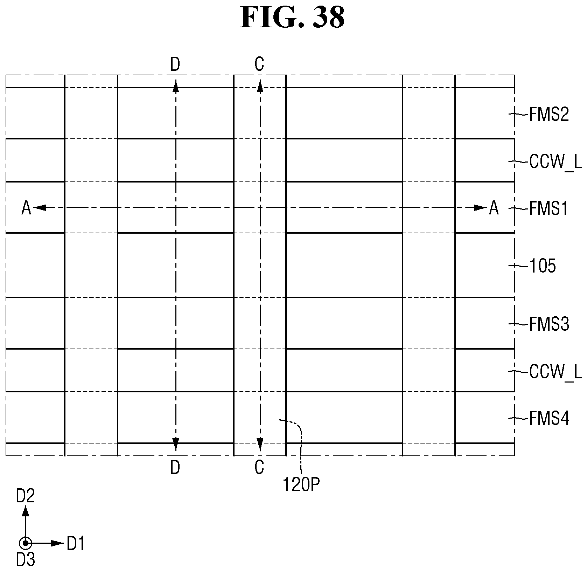

In addition, since the lower channel isolation structure CCW_L does not protrude more than the first to fourth mold fin-type patterns FMS 1, FMS2, FMS3, and FMS4, constraints of a subsequent fabricating process may be reduced. In addition, while a dummy gate electrode 120P (see FIGS. 38 to 41) is being formed, a skirt structure or the like might not be formed by the dummy gate electrode 120P. For example, process defects that may occur due to a skirt structure or the like may be reduced or eliminated.

The field insulating line pattern 105DP of FIG. 17 may be formed while the lower channel isolation structure CCW_L is formed. The first region CCW1_R1 of the first channel isolation structure of FIG. 4 and the first portion CCW1_R21 of the second region of the first channel isolation structure of FIG. 9 may be formed by the lower channel isolation structure CCW_L.

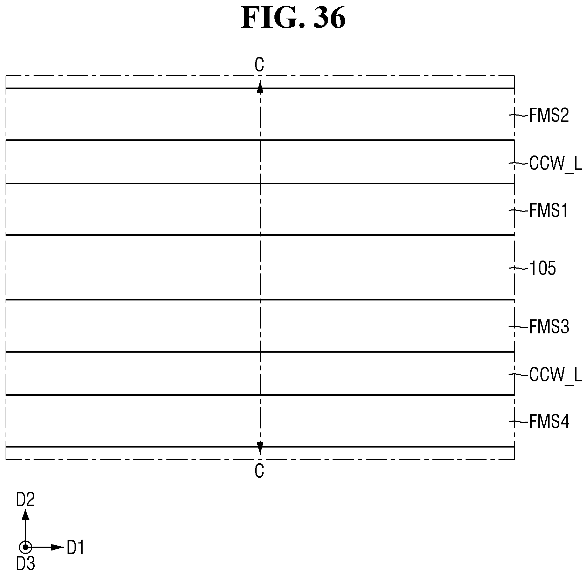

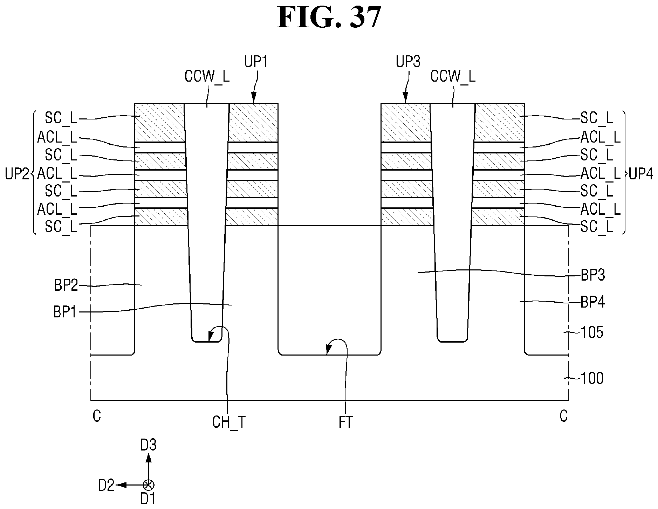

Referring to FIGS. 36 and 37, the field insulating layer 105 may be formed on the first substrate 100.

The field insulating layer 105 may fill a part of the fin trench FT.

Referring to FIGS. 38 to 41, a plurality of dummy gate electrodes 120P may be formed on the first to fourth mold fin-type patterns FMS1, FMS2, FMS3, and FMS4.

The plurality of dummy gate electrodes 120P may be formed on the lower channel isolation structure CCW_L.

Each of the dummy gate electrodes 120P may extend primarily in the second direction D2. The respective dummy gate electrodes 120P may be spaced apart in the first direction D1.

Each of the dummy gate electrodes 120P may intersect the first to fourth mold fin-type patterns FMS1, FMS2, FMS3, and FMS4. Each of the dummy gate electrodes 120P may intersect the lower channel isolation structure CCW_L.

For example, a pre-dummy gate insulating layer 130PP may be formed on the first to fourth mold fin-type patterns FMS1, FMS2, FMS3, and FMS4. The pre-dummy gate insulating layer 130PP may be formed along the profile of the first to fourth mold fin-type patterns FMS1, FMS2, FMS3, and FMS4 protruding more than the field insulating layer 105.

For example, the pre-dummy gate insulating layer 130PP may be formed using an oxidation process of oxidizing a semiconductor material. The pre-dummy gate insulating layer 130PP is not formed on the lower channel isolation structure CCW_L.

Subsequently, the plurality of dummy gate electrodes 120P may be formed on the pre-dummy gate insulating layer 130PP. The dummy gate electrode 120P may be formed using a dummy gate capping layer 120HM as a mask. While the dummy gate electrode 120P is formed, the pre-dummy gate insulating layer 130PP might not be removed.

The dummy gate electrode 120p may include, for example, polysilicon, but the present disclosure is not necessarily limited thereto. The dummy gate capping layer 120_HM may include, for example, silicon nitride, but the present disclosure is not necessarily limited thereto.

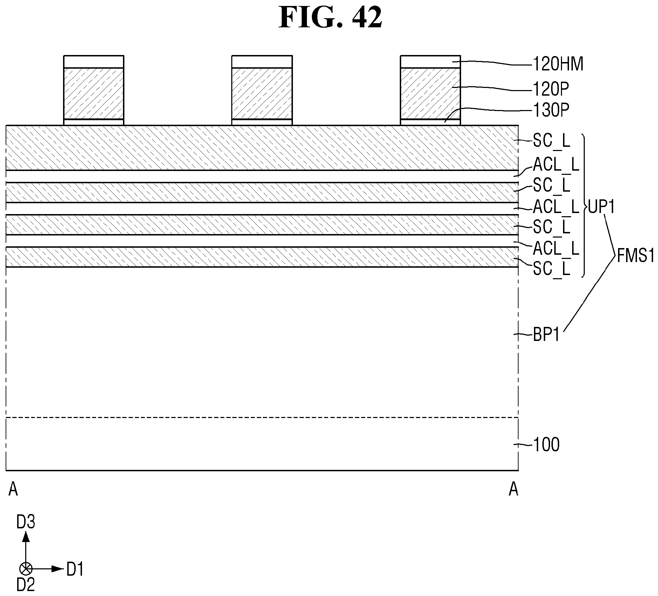

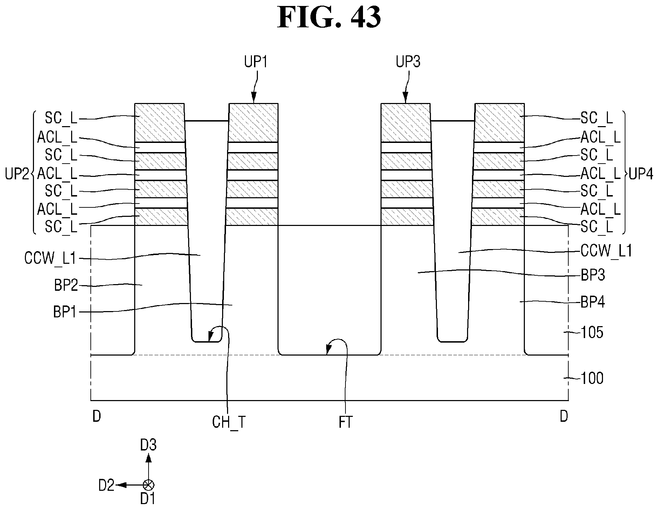

Referring to FIGS. 42 and 43, a part of the pre-dummy gate insulating layer 130PP may be removed to form the dummy gate insulating layer 130P.

The dummy gate insulating layer 130P is formed between the dummy gate electrode 120P and the first to fourth mold fin-type patterns FMS1, FMS2, FMS3, and FMS4. The dummy gate insulating layer 130P may be formed by removing the pre-dummy gate insulating layer 130PP exposed between the dummy gate electrodes 120P adjacent in the first direction D1.

While the dummy gate insulating layer 130P is formed, a first lower channel isolation structure CCW_L1 may be formed. The first lower channel isolation structure CCW_L1 may be formed by removing a part of the lower channel isolation structure CCW_L exposed between the adjacent dummy gate electrodes 120P. A portion of the lower channel isolation structure CCW_L overlapping the dummy gate electrode 120P in the third direction D3 might not be etched.

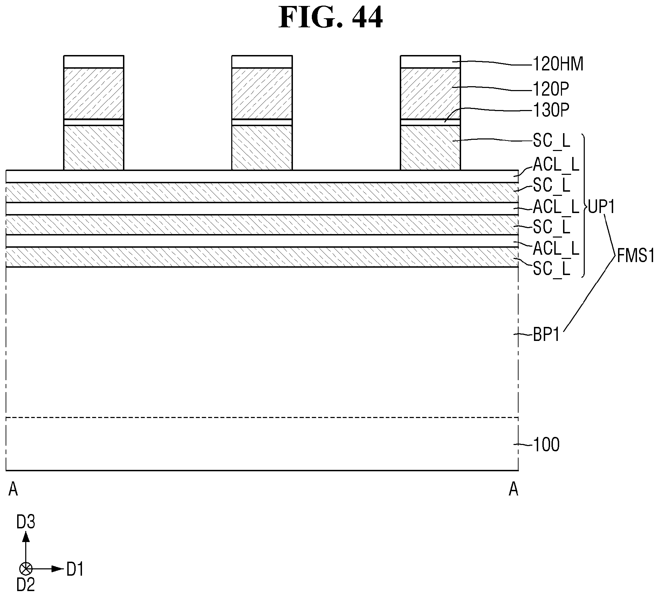

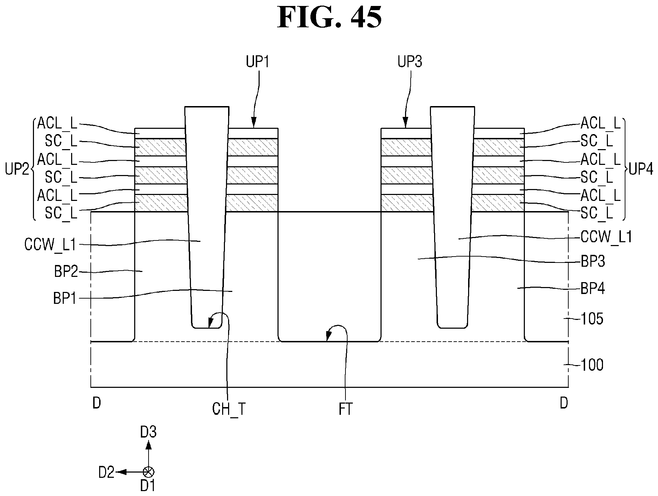

Referring to FIGS. 44 and 45, after the first lower channel isolation structure CCW_L1 is formed, the uppermost sacrificial pattern SC_L exposed between the dummy gate electrodes 120P may be removed.

The uppermost sacrificial pattern SC_L included in the first to fourth mold fin-type patterns FMS1, FMS2, FMS3, and FMS4 may be patterned using the dummy gate electrode 120P as a mask.

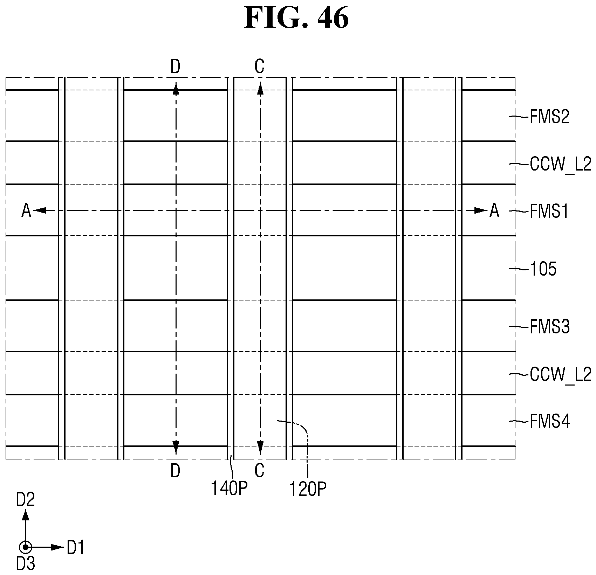

Referring to FIGS. 46 to 48, a dummy gate spacer 140P may be formed on a sidewall of the dummy gate electrode 120P.

While the dummy gate spacer 140P is formed, first to fourth source/drain recesses 150R, 250R, 350R, and 450R may be formed between the dummy gate electrodes 120P by using the dummy gate electrode 120P as a mask.

The first source/drain recess 150R may be formed in the first mold fin-type pattern FMS1. The second source/drain recess 250R may be formed in the second mold fin-type pattern FMS1. The third source/drain recess 350R may be formed in the third mold fin-type pattern FMS3. The fourth source/drain recess 450R may be formed in the fourth mold fin-type pattern FMS4.

The dummy gate spacer 140P may cover at least a part of the sidewall of the patterned uppermost sacrificial pattern SC_L.

After removing a part of the lower channel isolation structure CCW_L exposed between the adjacent dummy gate electrodes 120P, the first to fourth source/drain recesses 150R, 250R, 350R, and 450R may be formed. For example, after the first lower channel isolation structure CCW_L1 is formed, the first to fourth source/drain recesses 150R, 250R, 350R, and 450R may be formed.

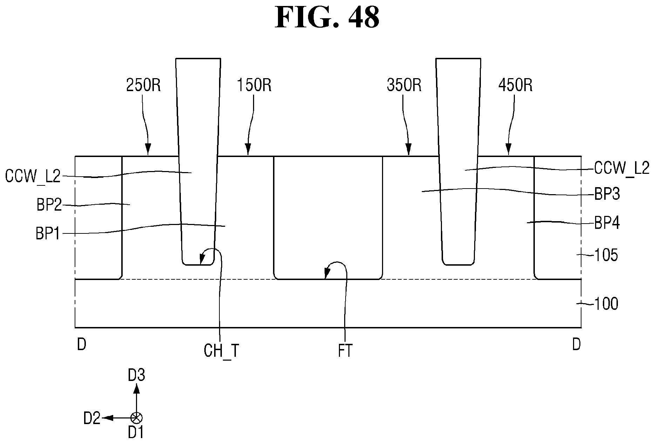

While the first to fourth source/drain recesses 150R, 250R, 350R, and 450R are formed, a second lower channel isolation structure CCW_L2 may be formed. The second lower channel isolation structure CCW_L2 may be formed by removing a part of the first lower channel isolation structure CCW_L1 exposed between the adjacent dummy gate electrodes 120P. A portion of the first lower channel isolation structure CCW_L1 overlapping the dummy gate electrode 120P in the third direction D3 might not be etched. For example, in the cross-sectional view of FIG. 48, the upper surface of the second lower channel isolation structure CCW_L2 is lower than the upper surface of the active pattern ACT_L disposed on an uppermost portion.

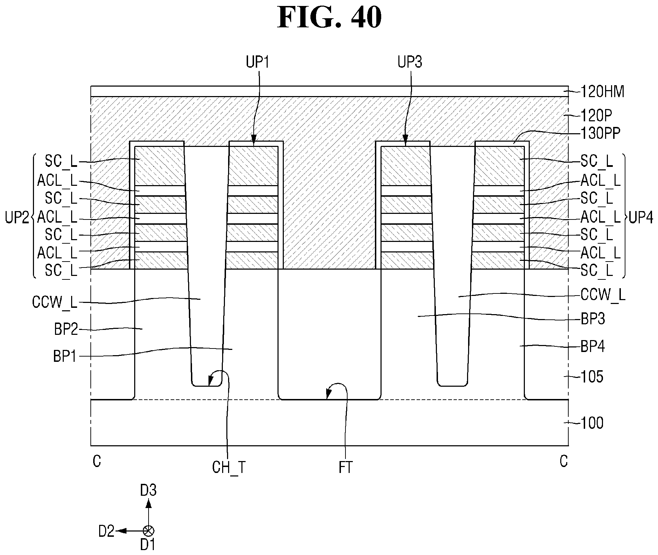

A cross-sectional view taken along line C-C of FIG. 46 may be the same as that of FIG. 40.

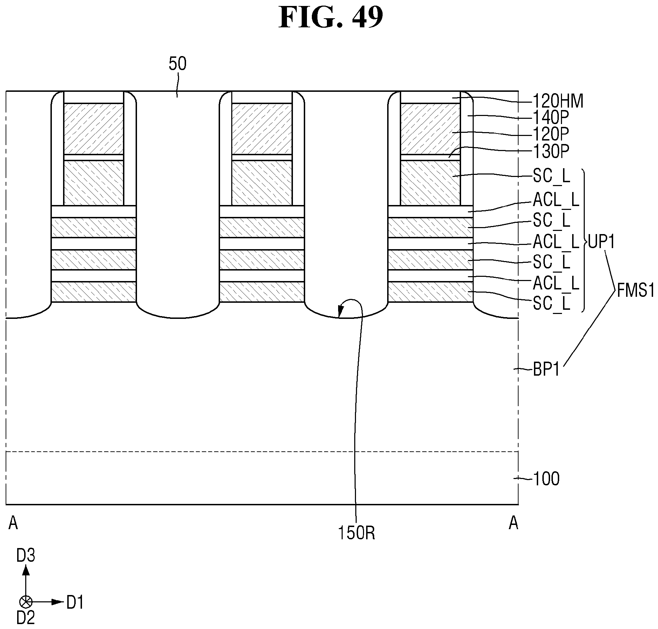

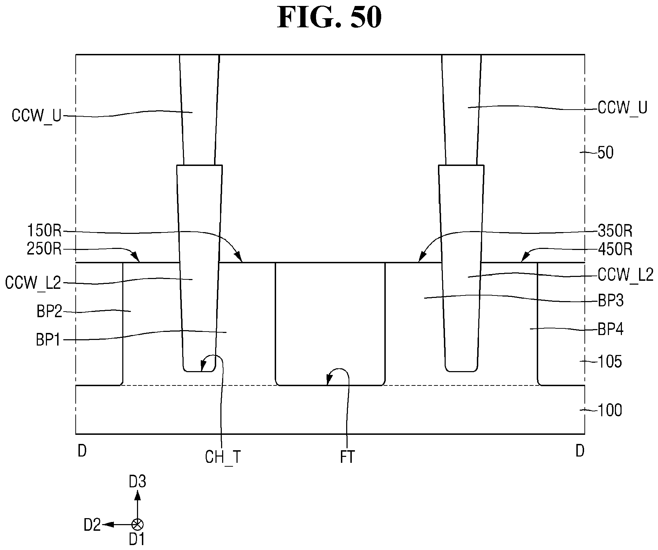

Referring to FIGS. 49 and 50, a sacrificial insulating layer 50 may be formed on the first substrate 100.

The sacrificial insulating layer 50 may fill the first to fourth source/drain recesses 150R, 250R, 350R, and 450R. The sacrificial insulating layer 50 may fill a space positioned between the dummy gate electrodes 120P. The sacrificial insulating layer 50 may be formed up to an upper surface of the dummy gate capping layer 120HM.

Subsequently, an upper channel isolation structure CCW_U is formed on the second lower channel isolation structure CCW_L2. The upper channel isolation structure CCW_U may be formed between the adjacent dummy gate electrodes 120P in the first direction D1. After the first to fourth source/drain recesses 150R, 250R, 350R, and 450R are formed, the upper channel isolation structure CCW_U is formed.

A second portion CCW1_R22 of the second region of the first channel isolation structure of FIG. 9 may be formed by the upper channel isolation structure CCW_U.

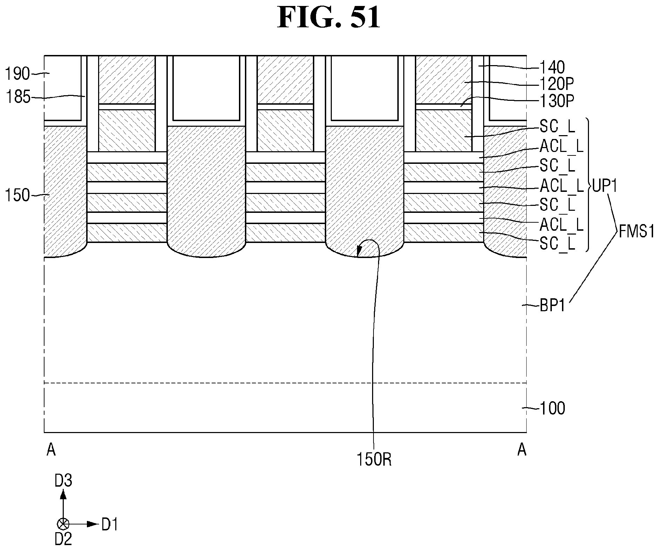

Referring to FIGS. 51 to 53, the sacrificial insulating layer 50 is removed.

Accordingly, the first to fourth source/drain recesses 150R, 250R, 350R, and 450R may be exposed. For example, the first to fourth upper pattern structures UP1, UP2, UP3, and UP4 may be exposed.

The first source/drain pattern 150 may be formed in the first source/drain recess 150R. The first source/drain pattern 150 may be formed on the first lower pattern BP1. The second source/drain pattern 250 may be formed in the second source/drain recess 250R. The second source/drain pattern 250 may be formed on the second lower pattern BP2. The third source/drain pattern 350 may be formed in the third source/drain recess 350R. The third source/drain pattern 350 may be formed on the third lower pattern BP3. The fourth source/drain pattern 450 may be formed in the fourth source/drain recess 450R. The fourth source/drain pattern 450 may be formed on the fourth lower pattern BP4.

Each of the first to fourth source/drain patterns 150, 250, 350, and 450 may be in contact with the upper channel isolation structure CCW_U and the second lower channel isolation structure CCW_L2.

Subsequently, the source/drain etch stop layer 185 and the upper interlayer insulating layer 190 may be formed on the source/drain patterns 150, 250, 350, and 450. While the source/drain etch stop layer 185 and the upper interlayer insulating layer 190 are formed, the dummy gate capping layer 120HM may be removed. The dummy gate electrode 120P may be exposed.

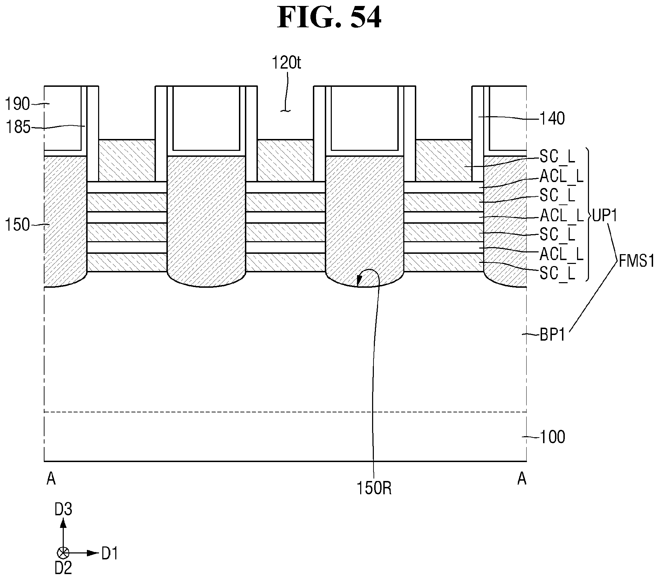

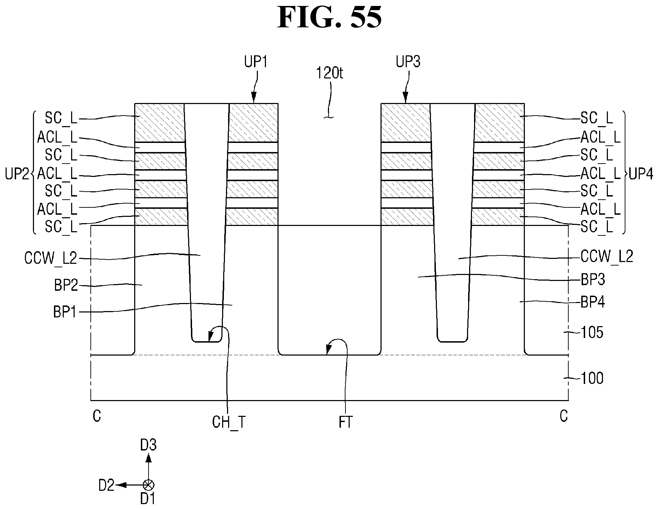

Referring to FIGS. 54 and 55, a gate trench 120t may be formed by removing the dummy gate electrode 120P and the dummy gate insulating layer 130P.

The gate trench 120t may expose the first to fourth upper pattern structures UP1, UP2, UP3, and UP4. The gate trench 120t may extend primarily in the second direction D2.

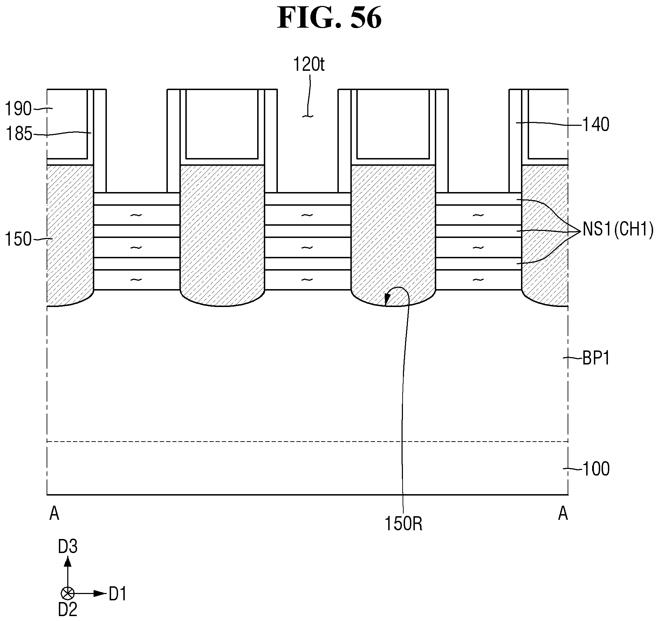

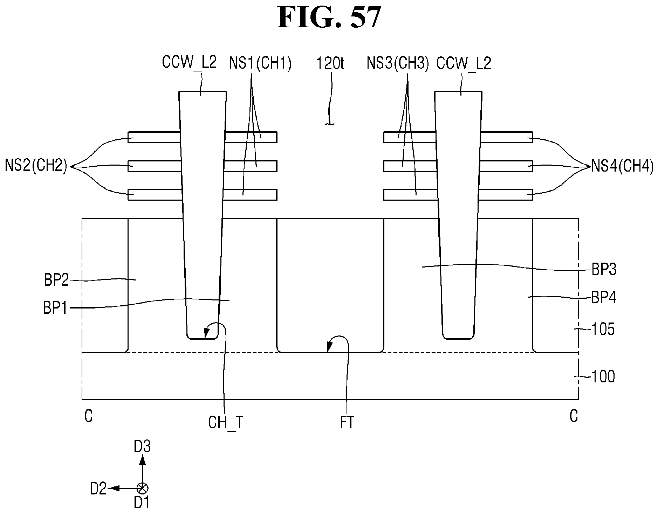

Referring to FIGS. 56 and 57, the first sheet pattern NS1 in contact with the second lower channel isolation structure CCW_L2 and the first source/drain pattern 150 may be formed by removing the sacrificial pattern SC_L of the first upper pattern structure UP1 exposed by the gate trench 120t.

The second sheet pattern NS2 in contact with the second lower channel isolation structure CCW_L2 and the second source/drain pattern 1250 may be formed by removing the sacrificial pattern SC_L of the second upper pattern structure UP2 exposed by the gate trench 120t.

The third sheet pattern NS3 and the fourth sheet pattern NS4 may be formed by removing the sacrificial pattern SC_L of the third and fourth upper pattern structures UP3 and UP4 exposed by the gate trench 120t. The third sheet pattern NS3 and the fourth sheet pattern NS4 may be in contact with the second lower channel isolation structure CCW_L2.

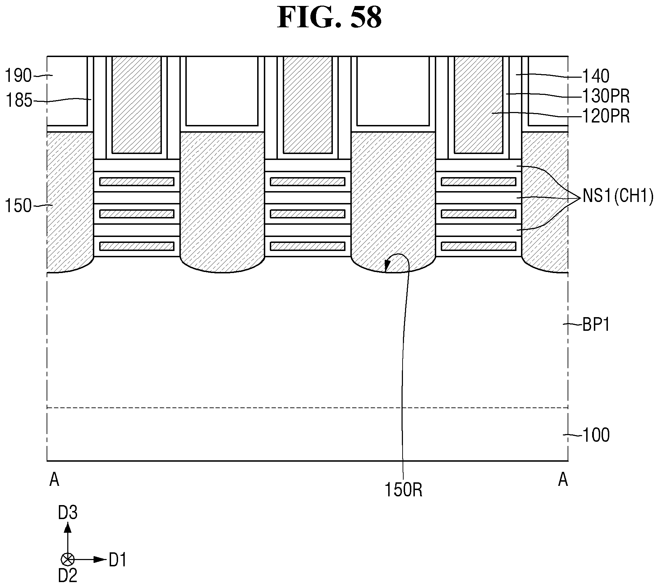

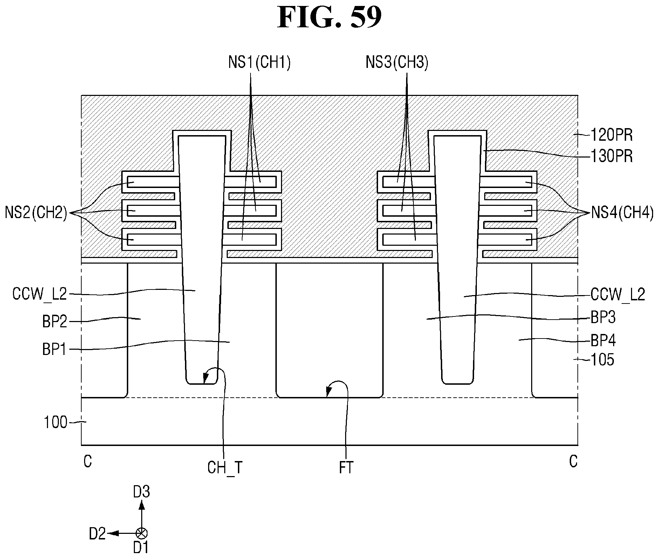

Referring to FIGS. 58 and 59, a pre-gate electrode 120PR and a pre-gate insulating layer 130PR may be formed in the gate trench 120t.

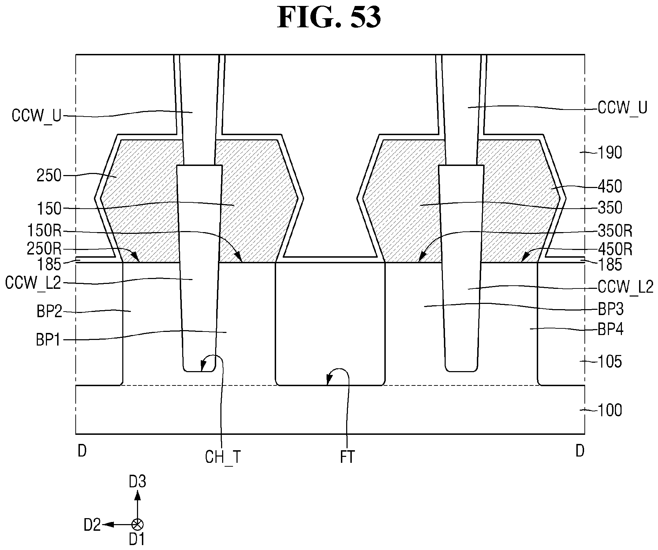

The pre-gate electrode 120PR may intersect the first to fourth sheet patterns NS1, NS2, NS3, and NS4. The pre-gate electrode 120PR may cover an upper surface of the second lower channel isolation structure CCW_L2. An upper surface of the pre-gate electrode 120PR may be on the same plane as an upper surface of the upper channel isolation structure CCW_U (see, FIG. 53).

In FIGS. 2 to 5, the first to fourth gate structures GS1, GS2, GS3, and GS4 may be formed by removing parts of the pre-gate electrode 120PR and the pre-gate insulating layer 130PR. The pre-gate electrode 120PR and the pre-gate insulating layer 130PR may be etched until the upper surface of the second lower channel isolation structure CCW_L2 is exposed. Accordingly, the first to fourth gate structures GS1, GS2, GS3, and GS4 may be formed. The first and second gate capping patterns 145 and 345 may be formed on the first to fourth gate structures GS1, GS2, GS3, and GS4.

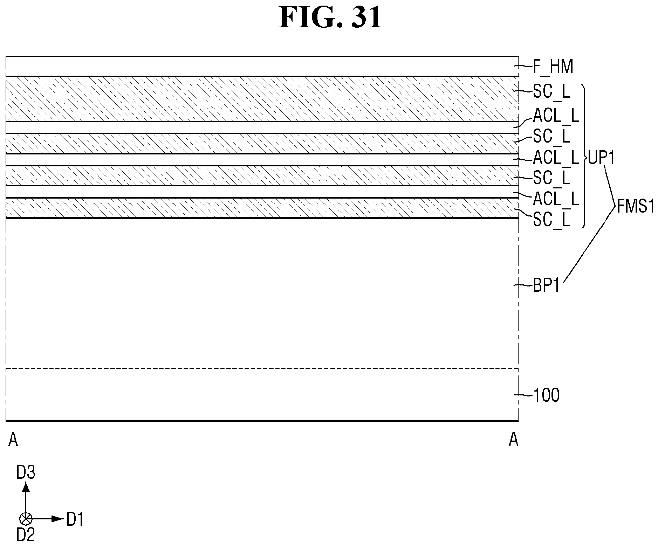

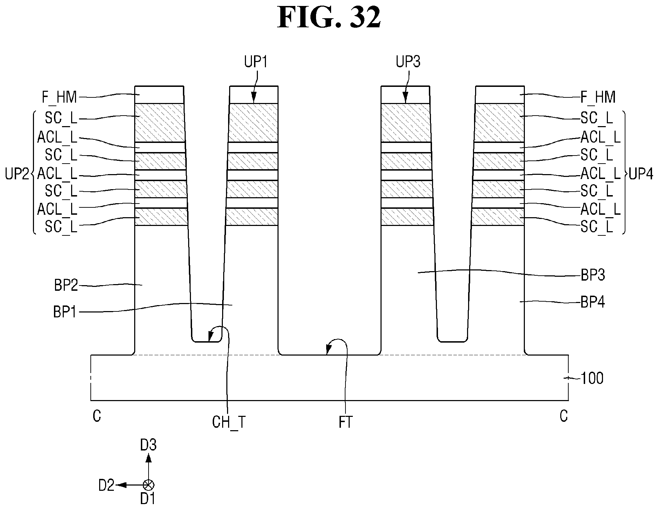

Unlike those illustrated in FIGS. 31 and 32, each of the first to fourth mold fin-type patterns FMS1, FMS2, FMS3, and FMS4 may further include a lower buffer pattern formed between the first to fourth lower patterns BP1, BP2, BP3, and BP4 and the first to the fourth upper pattern structures UP1, UP2, UP3, and UP4.

The lower buffer pattern may include a material having an etch selectivity with respect to the active pattern ACT_L and the sacrificial pattern SC_L. For example, the sacrificial pattern SC_L may include a silicon-germanium layer doped with carbon, and the lower buffer pattern may include a silicon-germanium layer. For example, the sacrificial pattern SC_L may include a silicon-germanium layer, and the lower buffer pattern may include a silicon-germanium layer doped with carbon. Depending on whether carbon is doped, the etching rate of the silicon-germanium layer may vary. For example, the sacrificial pattern SC_L may have an etch selectivity with respect to the lower buffer pattern.

In this case, the lower buffer pattern may be removed before forming the dummy gate spacer 140P described with reference to FIGS. 46 to 48. Subsequently, while the dummy gate spacer 140P is formed, the first to fourth lower insulating patterns BDI1, BDI2, BDI3, and BDI4 described with reference to FIGS. 22 to 26 may be formed in a space in which the lower buffer pattern is removed.

In concluding the detailed description, those skilled in the art will appreciate that many variations and modifications may be made to the described embodiments without substantially departing from the principles of the present inventive concept.

## Claims

1. A semiconductor device, comprising:
a lower pattern (BP1) extending primarily in a first direction (D1), and comprising a first sidewall (BP1_SW1) and a second sidewall (BP1_SW2) opposite to the first sidewall in a second direction (D2);
a channel isolation structure (CCW1) extending primarily in the first direction and in contact with a first sidewall (BP1_SW1) of the lower pattern (BP1);
a field insulating layer (105) in contact with the second sidewall (BP1_SW2) of the lower pattern;
a gate structure (GS1) disposed on the lower pattern (BP1), the gate structure being in contact with the channel isolation structure (CCW1), and extending primarily in the second direction (D2);
a channel pattern (CH1) disposed on the lower pattern (BP1), and comprising a plurality of sheet patterns (NS) spaced apart from one another in a third direction (D3), each of the plurality of sheet patterns being in contact with the channel isolation structure (CCW1); and
a source/drain pattern (150) in contact with both the channel pattern (CH1) and the channel isolation structure (CCW1),
wherein the channel isolation structure (CCW1) comprises a first region (CCW1_R1) in contact with the gate structure (GS1) and a second region (CCW1_R2) in contact with the source/drain pattern (150),
wherein the second region (CCW1_R2) of the channel isolation structure comprises a first portion and a second portion (CCW1_R21, CCW1_R22) whose widths increase in the second direction as a distance from a bottom surface of the field insulating layer (105) increases,
wherein the second portion (CCW1_R22) of the second region of the channel isolation structure is disposed on the first portion (CCW1_R21) of the second region of the channel isolation structure, and
wherein a width (W21) of an uppermost portion of the channel isolation structure (CCW1) in the first portion (CCW1_R21) of the second region of the channel isolation structure is greater than a width (W22) of a lowermost portion of the channel isolation structure in the second portion (CCW1_R22) of the second region of the channel isolation structure.

2. The semiconductor device of claim 1, wherein the second region of the channel isolation structure further comprises a third portion disposed between the first portion of the second region of the channel isolation structure and the second portion of the second region of the channel isolation structure, and
wherein in the third portion of the second region of the channel isolation structure, a width of the channel isolation structure in the second direction decreases as the distance from the bottom surface of the field insulating layer increases.

3. The semiconductor device of claim 1 or 2, wherein a width of the channel isolation structure in the second direction in the first region of the channel isolation structure continuously increases as the distance from the bottom surface of the field insulating layer increases.

4. The semiconductor device of claim 1, 2, or 3, wherein a height from the bottom surface of the field insulating layer to an uppermost portion of the first portion of the second region of the channel isolation structure is smaller than a height from the bottom surface of the field insulating layer to an uppermost portion of the source/drain pattern.

5. The semiconductor device of claim 4, wherein a part of the source/drain pattern overlaps the first portion of the second region of the channel isolation structure in the third direction.

6. The semiconductor device of any one of claims 1 to 5, wherein a height from the bottom surface of the field insulating layer to an uppermost portion of the first portion of the second region of the channel isolation structure is smaller than a height from the bottom surface of the field insulating layer to an upper surface of the channel pattern.

7. The semiconductor device of any one of claims 1 to 6, wherein each of the first portion of the second region of the channel isolation structure and the second portion of the second region of the channel isolation structure comprises a width center line extending primarily in the third direction, and
wherein the width center line of the first portion of the second region of the channel isolation structure is aligned with the width center line of the second portion of the second region of the channel isolation structure in the third direction.

8. The semiconductor device of any one of claims 1 to 7, wherein each of the first portion of the second region of the channel isolation structure and the second portion of the second region of the channel isolation structure comprises a width center line extending primarily in the third direction, and
wherein the width center line of the first portion of the second region of the channel isolation structure is spaced apart from the width center line of the second portion of the second region of the channel isolation structure in the second direction.

9. The semiconductor device of any one of claims 1 to 8, further comprising a lower insulating pattern disposed between the lower pattern and the channel pattern, and in contact with an upper surface of the lower pattern.

10. The semiconductor device of any one of claims 1 to 9, wherein a depth from an upper surface of the lower pattern to a lowermost portion of the channel isolation structure is smaller than or equal to a depth from the upper surface of the lower pattern to the bottom surface of the field insulating layer.

11. The semiconductor device of any one of claims 1 to 10, further comprising a sacrificial semiconductor pattern and a sacrificial pattern capping layer,
wherein the sacrificial semiconductor pattern overlaps the first source/drain pattern in the third direction, and
wherein the sacrificial pattern capping layer is disposed between the sacrificial semiconductor pattern and the first source/drain pattern.

12. The semiconductor device of any one of claims 1 to 11, further comprising:
a source/drain etch stop layer disposed on the source/drain pattern; and
an insertion source/drain oxide layer disposed between the source/drain etch stop layer and the source/drain pattern, and in contact with the source/drain pattern.

13. The semiconductor device of any one of claims 1 to 12, further comprising a source/drain fence disposed on the field insulating layer, and protruding in the third direction,
wherein the source/drain fence is in contact with the source/drain pattern.

14. The semiconductor device of any one of claims 1 to 13, further comprising a gate isolation structure disposed on the field insulating layer, and extending primarily in the first direction,
wherein the gate structure and the source/drain pattern are each disposed between the channel isolation structure and the gate isolation structure.

15. A semiconductor device, comprising:
a first gate structure (GS1) comprising a first gate electrode and a first gate insulating layer;
a second gate structure (GS2) comprising a second gate electrode and a second gate insulating layer, and spaced apart from the first gate structure in a first direction (D2);
a first source/drain pattern (150) disposed adjacent to the first gate structure in a second direction (D1);
a second source/drain pattern (250) disposed adjacent to the second gate structure in the second direction, and spaced apart from the first source/drain pattern in the first direction;
a channel isolation structure (CCW1) disposed between the first gate structure and the second gate structure and between the first source/drain pattern and the second source/drain pattern, the channel isolation structure extending primarily in the second direction (D1);
a first channel pattern (CH1) comprising a plurality of first sheet patterns, each of the first sheet patterns being in contact with the channel isolation structure (CCW1) and the first source/drain pattern (150); and
a second channel pattern (CH2) comprising a plurality of second sheet patterns, each of the second sheet patterns being in contact with the channel isolation structure (CCW1) and the second source/drain pattern (250),
wherein a width (W11) of the channel isolation structure (CCW1) between the first gate structure (GS1) and the second gate structure (GS2) in the first direction (D2) is different from a width (W12) of the channel isolation structure (CCW1) in the first direction (D2) between the first source/drain pattern (150) and the second source/drain pattern (250).
